# EUROPÄISCHE PATENTSCHRIFT

(11) **EP 2 870 625 B1**
(45) Veröffentlichungstag und Bekanntmachung des Hinweises auf die Patenterteilung: **06.01.2021**
(21) Anmeldenummer: 13737582.0
(22) Anmeldetag: 09.07.2013
(51) Int. Cl.: H01L 21/673, H01L 21/677, H01L 21/67

(54) **ANLAGE UND VERFAHREN ZUM PROZESSIEREN VON SUBSTRATEN**
ASSEMBLY AND METHOD FOR PROCESSING SUBSTRATES
INSTALLATION ET PROCÉDÉ DESTINÉS À TRAITER DES SUBSTRATS

(30) Priorität: 09.07.2012 EP 12175591
(43) Veröffentlichungstag der Anmeldung: 13.05.2015
(73) Patentinhaber: (CNBM) Bengbu Design & Research Institute for Glass Industry Co., Ltd., Bengbu (CN)
(72) Erfinder: JOST, Stefan, 81543 München (DE); FÜRFANGER, Martin, 85643 Steinhöring (DE); PALM, Jörg, 80797 München (DE)
(74) Vertreter: Gebauer, Dieter Edmund
(86) Internationale Anmeldenummer: PCT/EP2013/064517
(87) Internationale Veröffentlichungsnummer: WO 2014/009387

(56) Entgegenhaltungen:
- EP-A1- 2 144 026
- WO-A1-2012/025607
- CN-A- 102 024 870
- US-A- 5 217 053
- US-A1- 2002 124 906
- US-A1- 2005 238 476

## Beschreibung

Die Erfindung betrifft eine Anlage und ein Verfahren zum Prozessieren von beschichteten Substraten in Prozessboxen. Photovoltaische Schichtensysteme zur direkten Umwandlung von Sonnenlicht in elektrische Energie sind hinlänglich bekannt. Diese werden gemeinhin als "Solarzellen" bezeichnet, wobei sich der Begriff "Dünnschichtsolarzellen" auf Schichtensysteme mit geringen Dicken von nur wenigen Mikrometern bezieht, welche Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit Absorbern aus Verbindungshalbleitern als vorteilhaft erwiesen. In der Patentliteratur wurden Dünnschichtsolarzellen bereits vielfach beschrieben. Lediglich beispielhaft sei diesbezüglich auf die Druckschriften DE 4324318 C1 und EP 2200097 A1 verwiesen.

In Dünnschichtsolarzellen werden überwiegend Verbindungshalbleiter aus Chalkopyritverbindungen, insbesondere Kupfer-Indium/Gallium-Dischwefel/Diselenid, abgekürzt durch die Formel Cu(In,Ga)(S,Se)₂, oder Kesterit-Verbindungen, insbesondere Kupfer-Zink/Zinn-Dischwefel/Diselenid, abgekürzt durch die Formel Cu₂(Zn,Sn)(S,Se)₄ als Absorber eingesetzt. Von den verschiedenen Möglichkeiten den Verbindungshalbleiter herzustellen, haben sich in den letzten Jahren im Wesentlichen zwei Verfahren durchgesetzt. Dies ist die Ko-Verdampfung der Einzelelemente auf ein heißes Substrat sowie das sukzessive Aufbringen der Elemente in Einzelschichten (Vorläufer- bzw. Prescursorschichten) auf ein kaltes Substrat, beispielsweise durch Sputtern, verbunden mit einer schnellen Wärmebehandlung (RTP = Rapid Thermal Processing), bei der die eigentliche Kristallbildung und Phasenumwandlung der Vorläuferschichten zum Verbindungshalbleiter erfolgt. Die letztgenannte zweistufige Vorgehensweise ist beispielsweise in J. Palm et al., "CIS module pilot processing applying concurrent rapid selenization and sulfurization of large area thin film precursors", Thin Solid Films 431-432, S. 414-522 (2003) eingehend beschrieben.

In der großtechnischen Fertigung von Dünnschichtsolarmodulen erfolgt die RTP-Wärmebehandlung von Vorläuferschichten in In-Line-Anlagen, in denen die beschichteten Substrate der Reihe nach verschiedenen Prozesskammern zugeführt werden. Ein solches Verfahren ist beispielsweise aus der EP 0662247 B1 bekannt.

Die RTP-Wärmebehandlung von Vorläuferschichten ist ein komplexer Prozess der schnelle Aufheizraten im Bereich einiger K/s, eine homogene Temperaturverteilung über das Substrat (lateral) und über die Substrat-Dicke, Maximal-Temperaturen oberhalb von 500°C, sowie eine genaue Kontrolle der Prozessatmosphäre erfordert. Insbesondere ist bei der Herstellung einer Chalkopyritverbindung ein ausreichend hoher, kontrollierbarer und reproduzierbarer Partialdruck der auf das Substrat aufgebrachten leichtflüchtigen Chalkogenelemente (Se und/oder S) und eine kontrollierte Prozessgas-Zufuhr (z.B. H₂, N₂, Ar, H₂S, H₂Se, S-Gas, Se-Gas) zu gewährleisten. Beispielsweise erfordert eine In-Line-Selenisierung eines metallischen CuInGa-Vorläuferschichtenstapels eine ausreichende Se-Menge für eine vollständige Selenisierung. Ein deutlicher Se-Verlust führt zu einer unvollständigen Umwandlung der Vorläuferschichten zur Chalkopyritverbindung und selbst ein schwacher Se-Verlust resultiert in einer Leistungseinbuße des fertigen Dünnschichtsolarmoduls.

Es ist bekannt, den Prozessraum um das beschichtete Substrat durch eine Prozessbox zu begrenzen. Die Prozessbox ermöglicht, den Partialdruck von leicht flüchtigen Chalkogenkomponenten, wie Selen oder Schwefel, während der Wärmebehandlung zumindest weitestgehend konstant zu halten. Außerdem wird die Exposition der Prozesskammer mit korrosiven Gasen reduziert. Eine solche Prozessbox ist beispielsweise aus der DE 102008022784 A1 bekannt.

In den zur großtechnischen Fertigung von Dünnschichtsolarmodulen eingesetzten In-Line-Anlagen durchlaufen die beschichteten Substrate bzw. die damit beladenen Prozessboxen verschiedene Prozesskammern im Indexbetrieb, wobei sie taktweise in die jeweils nächste Prozesskammer transportiert werden. Die Prozesskammern sind generell als evakuierbare Kammern ausgeführt, da die gesamte Prozessstrecke zum Entfernen von Sauerstoff und Wasser abgepumpt werden muss. Obgleich eine Prozessierung der Substrate üblicher Weise bei Normaldruck oder geringem Unterdruck erfolgt, ist eine Gasdichtigkeit der Prozesskammern erforderlich, um die Eindiffusion von Sauerstoff und Wasser in die Prozessstrecke und das Ausströmen von toxischen Gasen zu vermeiden. Lediglich Eingangs- und Ausgangsschleusen werden zyklisch abgepumpt.

Eine In-Line-Anlage mit Prozessboxen ist etwa in der CN 102 024 870 A gezeigt.

Allgemein ist die Konstruktion von evakuierbaren Prozesskammern komplex und technisch anspruchsvoll, da die erforderliche Vakuumdichtigkeit höchste Anforderungen an die verwendeten Materialien und Anlagenkomponenten wie Vakuumdurchführungen, insbesondere Drehdurchführungen, Ventile, Transportrollen, Gasandockeinrichtungen, Kühlplatten und Vakuumschieber stellen. Aus diesem Grund nehmen die Investitionskosten für diesen Prozessschritt einen nicht unwesentlichen Anteil an den gesamten Investitionskosten einer Solarfabrik ein. Zudem hat sich in der Praxis gezeigt, dass diese technisch aufwändigen und vergleichsweise teuren Komponenten durch den Transport der beschichteten Substrate bzw. Prozessboxen, das Aufheizen auf hohe Maximaltemperaturen von mehr als 500°C, sowie durch die korrosive Prozessatmosphäre einem deutlich erhöhten Verschleiß ausgesetzt sind und undicht werden können. Bei einem Ausfall ist die komplette Fertigungskette durch die erforderlichen Wartungsarbeiten unterbrochen.

Die US-Patentanmeldung Nr. 2005/0238476 A1 zeigt eine Vorrichtung zum Transportieren eines Substrats in einer kontrollierten Atmosphäre mit einem Gehäuse, das einen evakuierbaren Substratraum für das Substrat und einen Nebenraum umfasst. Substrat- und Nebenraum sind durch eine Trennwand mit Nanoporen voneinander getrennt, wobei die Trennwand eine auf dem Knudsen-Prinzip (Thermoosmose) basierende Mikropumpe bildet. Der Substratraum weist eine Kühlplatte (Dekontaminationsplatte) auf, wobei die Trennwand nicht zwischen Substrat und Kühlplatte angeordnet ist. Vielmehr ist die Kühlplatte stets in gegenüberliegender Position zum Substrat angeordnet. Zudem ist der Nebenraum durch die heizbare Trennwand von dem durch die Kühlplatte gekühlten Gehäuseabschnitt bzw. Substratraum thermisch abgekoppelt. Für den Pumpmechanismus ist eine Heizung erforderlich.

Demgegenüber liegt die Aufgabe der vorliegenden Erfindung darin, eine Möglichkeit zu schaffen, beschichtete Substrate in einer technisch wesentlich einfacheren und kostengünstigeren Anlage einer Wärmebehandlung zu unterziehen. Diese und weitere Aufgaben werden nach dem Vorschlag der Erfindung durch eine Anlage und ein Verfahren zum Prozessieren beschichteter Substrate gemäß den nebengeordneten Patentansprüchen gelöst. Bevorzugte Ausführungsformen der Erfindung gehen aus den Merkmalen der Unteransprüche hervor.

Erfindungsgemäß ist eine Anlage zum Prozessieren beschichteter Substrate gezeigt, welche eine oder mehrere Prozessboxen umfasst. Die Prozessboxen sind jeweils zum Aufnehmen wenigstens eines Substrats vorgesehen und umfassen ein gasdicht verschließbares (evakuierbares) Gehäuse, das einen Hohlraum formt. Das Gehäuse umfasst wenigstens einen Gehäuseabschnitt, der so ausgebildet ist, dass das Substrat durch auf den Gehäuseabschnitt auftreffende elektromagnetische Heizstrahlung wärmebehandelbar ist. Zudem ist das Gehäuse mit wenigstens einer in den Hohlraum mündenden, verschließbaren Gasdurchführung zum Evakuieren und Einleiten von Gas in den Hohlraum versehen.

Die Anlage umfasst weiterhin wenigstens eine Be-/Entladeeinheit zum Beladen der Prozessbox mit einem Substrat und/oder Entnehmen des Substrats aus der Prozessbox, wenigstens eine Heizeinheit zum Aufheizen (Wärmebehandeln) des Substrats in der Prozessbox, wenigstens eine Kühleinheit zum Kühlen des Substrats in der Prozessbox, sowie wenigstens eine Abpumpeinrichtung zum Abpumpen des Hohlraums der Prozessbox und wenigstens eine Gasversorgungseinrichtung zum Speisen des Hohlraums der Prozessbox mit wenigstens einem Gas, insbesondere einem Spül- und/oder Prozessgas.

Des Weiteren umfasst die Anlage wenigstens einen Transportmechanismus, welcher dazu ausgebildet ist, eine Relativbewegung zwischen einerseits der Prozessbox und andererseits der Heiz-, Kühl- und Be-/Entladeeinheit auszuführen. Hierbei kann der Transportmechanismus dazu ausgebildet sein, eine transportierbare Prozessbox relativ zur ortsfesten Heiz-, Kühl- und Be-/Entladeeinheit zu bewegen. Alternativ ist die Prozessbox ortsfest und der Transportmechanismus ist dazu ausgebildet, die Heiz- und/oder Kühl- und/oder Be-/Entladeeinheit relativ zur ortsfesten Prozessbox zu bewegen. Hierbei können die Heiz-, Kühl- und Be-/Entladeeinheit jeweils einzeln, unabhängig von den jeweils anderen Einheiten bewegt werden. Möglich ist jedoch auch, dass die Heiz-, Kühl- und Be-/Entladeeinheit gemeinsam (synchron) bewegt werden.
In der erfindungsgemäßen Anlage ist es somit nicht erforderlich, die Heiz-, Kühl- und Be-/Entladeeinheit als evakuierbare Prozesskammern auszubilden, wobei die Anlage technisch sehr einfach ausgebildet werden kann, so dass die Investitions- und Wartungskosten vergleichsweise gering sind. Zudem unterliegen die Einheiten einem vergleichsweise geringen Verschleiß, da durch die gasdicht verschließbaren Prozessboxen eine Belastung mit korrosiven Substanzen vermieden werden kann.

Dementsprechend sind bei einer vorteilhaften Ausgestaltung der erfindungsgemäßen Anlage die Be-/Entladeeinheit, die Heizeinheit und die Kühleinheit jeweils als nicht-evakuierbare Einheiten ausgebildet. Dem steht nicht entgegen, dass die Heiz-, Kühl- und Be-/Entladeeinheit von einer gemeinsamen Einhausung oder einer jeweils einzelnen Einhausung umgeben sein können, die insbesondere an eine Abluftabsaugung angeschlossen sein kann, wobei die Einhausungen aber nicht als evakuierbare Kammern ausgebildet sind.

Bei einer vorteilhaften Ausgestaltung der erfindungsgemäßen Anlage sind die Abpumpeinrichtung und die Gasversorgungseinrichtung in die Be-/Entladeeinheit integriert, was für die Wärmebehandlung von Substraten prozesstechnisch vorteilhaft sein kann.

Die erfindungsgemäße Anlage umfasst eine oder mehrere Prozessboxen, bei denen das Gehäuse wenigstens einen mit einer Temperier- bzw. Kühleinrichtung zu dessen Temperierung bzw. aktiven Kühlung (wärmetechnisch) koppelbaren bzw. gekoppelten (ersten) Gehäuseabschnitt und insbesondere wenigstens einen nicht temperierbaren bzw. nicht kühlbaren, d. h. nicht mit der Kühleinrichtung thermisch gekoppelten, (zweiten) Gehäuseabschnitt aufweist. Die ersten Gehäuseabschnitte sind beispielsweise an die Kühleinrichtung (strömungstechnisch) angeschlossen bzw. anschließbar und können daher gekühlt werden, wohingegen die zweiten Gehäuseabschnitte an die Kühleinrichtung nicht angeschlossen sind und daher nicht gekühlt werden können. Der erste Gehäuseabschnitt ist verschieden vom zweiten Gehäuseabschnitt. Bei dem nicht kühlbaren zweiten Gehäuseabschnitt handelt es insbesondere um jenen Gehäuseabschnitt, der so ausgebildet ist, dass das Substrat durch auf den Gehäuseabschnitt auftreffende elektromagnetische Heizstrahlung wärmebehandelbar ist. Durch die Temperierung bzw. Kühlung des ersten Gehäuseabschnitts kann ein erhöhter Verschleiß von vakuumfähigen Bestandteilen der Prozessbox vermieden werden.

Zudem ist der Hohlraum der Prozessbox durch wenigstens eine Trennwand in einen Prozessraum zum Aufnehmen des Substrats und einen Zwischenraum unterteilt, wobei die Trennwand über eine oder mehrere Öffnungen verfügt und zwischen dem Substrat und dem durch die Kühleinrichtung temperierbaren ersten Gehäuseabschnitt angeordnet ist. Durch die Trennwand kann ein Kondensieren von gasförmigen Stoffen, die während der Wärmebehandlung im Prozessraum gebildet werden, am ersten Gehäuseabschnitt vermieden werden.

Die erfindungsgemäße Anlage umfasst weiterhin eine solche Temperier- bzw. Kühleinrichtung zur Temperierung bzw. aktiven Kühlung des ersten Gehäuseabschnitts der Prozessbox.

Bei einer vorteilhaften Ausgestaltung der erfindungsgemäßen Anlage sind die Be-/Entladeeinheit, die Heizeinheit und die Kühleinheit entlang einer umlaufenden Transportstrecke für die Prozessboxen jeweils ortsfest angeordnet, und zwar dergestalt, dass die Transportstrecke unidirektional von den Prozessboxen durchlaufen werden kann, um Substrate zu prozessieren. Der Transportmechanismus ist in diesem Fall dazu ausgebildet, die Prozessboxen unidirektional zu transportieren.

Eine weitere vorteilhafte Ausgestaltung der erfindungsgemäßen Anlage umfasst eine reihenförmige Anordnung von ortsfesten Einheiten, bestehend aus einer Heizeinheit, zwei Kühleinheiten, die sich beiderseits der Heizeinheit befinden, und zwei Be-/Entladeeinheiten zum Be- und/oder Entladen der Prozessbox, zwischen denen sich die anderen Einheiten befinden, wobei die Prozessboxen transportierbar sind und der Transportmechanismus für einen bidirektionalen Transport der Prozessboxen ausgebildet ist. Alternativ sind die genannten Einheiten der Anordnung dieser Ausgestaltung der Anlage transportierbar und die Prozessboxen sind ortsfest, wobei der Transportmechanismus für einen bidirektionalen Transport der Einheiten ausgebildet ist.

Eine weitere vorteilhafte Ausgestaltung der erfindungsgemäßen Anlage umfasst eine reihenförmige Anordnung von ortsfesten Gruppen von Einheiten, wobei die Gruppen jeweils aus einer Kühleinheit, einer Heizeinheit, einer Kühleinheit sowie einer Be-/Entladeeinheit, insbesondere in dieser Reihenfolge, bestehen, wobei die Prozessboxen transportierbar sind und der Transportmechanismus für einen bidirektionalen Transport der Prozessboxen ausgebildet ist. Alternativ hierzu sind die Einheiten jeweils transportierbar und die Prozessboxen sind ortsfest, wobei der Transportmechanismus für einen bidirektionalen Transport der Einheiten ausgebildet ist.

Eine weitere vorteilhafte Ausgestaltung der erfindungsgemäßen Anlage umfasst eine reihenförmige Anordnung von ortsfesten Gruppen von Einheiten, wobei die Gruppen jeweils aus einer Kühleinheit, einer Heizeinheit und einer Be-/Entladeeinheit, insbesondere in dieser Reihenfolge, bestehen, wobei die Prozessboxen transportierbar sind und der Transportmechanismus für einen bidirektionalen Transport der Prozessboxen ausgebildet ist. Alternativ hierzu sind die Einheiten jeweils transportierbar und die Prozessboxen sind ortsfest, wobei der Transportmechanismus für einen bidirektionalen Transport der Einheiten ausgebildet ist.

Bei einer weiteren vorteilhaften Ausgestaltung der erfindungsgemäßen Anlage sind die Abpumpeinrichtung und/oder die Gasversorgungseinrichtung und/oder die Temperier- bzw. Kühleinrichtung während einer Relativbewegung zwischen einerseits der Prozessbox und andererseits der Heiz-, Kühl- und Be-/Entladeeinheit permanent an eine Prozessbox angekoppelt.

Die Erfindung erstreckt sich weiterhin auf ein Verfahren zum Prozessieren beschichteter Substrate, welches die folgenden Schritte umfasst:
- Beladen eines Hohlraums einer evakuierbaren Prozessbox mit wenigstens einem beschichteten Substrat,
- gasdichtes Verschließen des Hohlraums der Prozessbox,
- Abpumpen des Hohlraums der Prozessbox,
- Befüllen des Hohlraums der Prozessbox mit wenigstens einem Gas, insbesondere zum Spülen des Hohlraums mit wenigstens einem Inertgas und/oder zum Befüllen des Hohlraums mit wenigstens einem Prozessgas, wobei der Hohlraum mit Unter- oder Überdruck befüllbar ist,
- Wärmebehandeln des Substrats durch elektromagnetische Heizstrahlung, die von außerhalb der Prozessbox angeordneten Heizstrahlern erzeugt wird und auf wenigstens einen zur Wärmebehandlung dienenden Gehäuseabschnitt der Prozessbox auftrifft,
- Kühlen des heißen Substrats,
- Entnehmen des Substrats aus der Prozessbox.

Bei einer vorteilhaften Ausgestaltung des erfindungsgemäßen Verfahrens, bei welchem die Prozessbox entlang einer geschlossenen Transportstrecke unidirektional umläuft, wird die Prozessbox nacheinander in eine Beladeeinheit zum Beladen der Prozessbox mit einem Substrat, wenigstens eine Heizeinheit zum Wärmebehandeln des Substrats, wenigstens eine Kühleinheit zum Kühlen des Substrats, sowie eine Entladeeinheit zum Entnehmen des Substrats aus der Prozessbox transportiert.

Eine weitere vorteilhafte Ausgestaltung des erfindungsgemäßen Verfahrens umfasst die folgenden Schritte:
- Beladen einer transportierbaren Prozessbox durch eine ortsfeste Be-/Entladeeinheit mit einem Substrat,
- Transportieren der Prozessbox, insbesondere in einer Richtung, zu einer ortsfesten Heizeinheit und Wärmebehandeln des Substrats,
- Transportieren der Prozessbox, insbesondere in der einen oder entgegen gesetzten Richtung, zu einer ortsfesten Kühleinheit und Kühlen des Substrats,
- Transportieren der Prozessbox, insbesondere in der entgegen gesetzten Richtung, zur Be-/Entladeeinheit und Entnehmen des Substrats.

Eine alternative Ausgestaltung des erfindungsgemäßen Verfahrens umfasst die folgenden Schritte:
- Beladen einer ortsfesten Prozessbox durch eine transportierbare Be-/Entladeeinheit mit einem Substrat,
- Entfernen der Be-/Entladeeinheit, insbesondere in einer Richtung, von der Prozessbox,
- Transportieren einer Heizeinheit, insbesondere in der einen Richtung, zur Prozessbox und Wärmebehandeln des Substrats,
- Entfernen der Heizeinheit, insbesondere in der anderen Richtung, von der Prozessbox,
- Transportieren einer Kühleinheit, insbesondere in der einen oder entgegen gesetzten Richtung, zur Prozessbox und Kühlen des Substrats,
- Entfernen der Kühleinheit, insbesondere in der einen oder entgegen gesetzten Richtung, von der Prozessbox,
- Transportieren der Be-/Entladeeinheit, insbesondere in der entgegen gesetzten Richtung, zur Prozessbox und Entnehmen des Substrats.

Eine weitere vorteilhafte Ausgestaltung des erfindungsgemäßen Verfahrens umfasst die folgenden Schritte:
- Beladen einer transportierbaren ersten Prozessbox durch eine ortsfeste erste Be-/Entladeeinheit mit einem ersten Substrat,
- Beladen einer transportierbaren zweiten Prozessbox durch eine ortsfeste zweite Be-/Entladeeinheit mit einem zweiten Substrat,
- Transportieren der ersten Prozessbox, insbesondere in einer Richtung, zu einer ortsfesten Heizeinheit und Wärmebehandeln des ersten Substrats,
- Transportieren der ersten Prozessbox, insbesondere in der entgegen gesetzten Richtung, zu einer ortsfesten ersten Kühleinheit und Kühlen des ersten Substrats,
- Transportieren der zweiten Prozessbox, insbesondere in der entgegen gesetzten Richtung, zur Heizeinheit und Wärmebehandeln des zweiten Substrats,
- Transportieren der zweiten Prozessbox, insbesondere in der einen Richtung, zu einer ortsfesten zweiten Kühleinheit und Kühlen des zweiten Substrats,
- Transportieren der ersten Prozessbox, insbesondere in der entgegen gesetzten Richtung, zur ersten Be-/Entladeeinheit und Entnehmen des ersten Substrats,
- Transportieren der zweiten Prozessbox, insbesondere in der einen Richtung, zur zweiten Be-/Entladeeinheit und Entnehmen des zweiten Substrats.

Eine alternative Ausgestaltung des erfindungsgemäßen Verfahrens umfasst die folgenden Schritte:
- Beladen einer ortfesten ersten Prozessbox durch eine erste Be-/Entladeeinheit mit einem ersten Substrat,
- Entfernen der ersten Be-/Entladeeinheit, insbesondere in einer Richtung, von der ersten Prozessbox,
- Beladen einer ortsfesten zweiten Prozessbox durch eine zweite Be-/Entladeeinheit mit einem zweiten Substrat,
- Entfernen der zweiten Be-/Entladeeinheit, insbesondere in der entgegen gesetzten Richtung, von der zweiten Prozessbox,
- Transportieren einer Heizeinheit, insbesondere in der einen Richtung, zur ersten Prozessbox und Wärmebehandeln des ersten Substrats,
- Entfernen der Heizeinheit, insbesondere in der entgegen gesetzten Richtung, von der ersten Prozessbox,
- Transportieren einer ersten Kühleinheit, insbesondere in der einen Richtung, zur ersten Prozessbox, und Kühlen des ersten Substrats,
- Entfernen der ersten Kühleinheit, insbesondere in der entgegen gesetzten Richtung, von der ersten Prozessbox,
- Transportieren der Heizeinheit, insbesondere in der entgegen gesetzten Richtung, zur zweiten Prozessbox und Wärmebehandeln des zweiten Substrats,
- Entfernen der Heizeinheit, insbesondere in der einen Richtung, von der zweiten Prozessbox, und Wärmebehandeln des zweiten Substrats,
- Transportieren einer zweiten Kühleinheit, insbesondere in der entgegen gesetzten Richtung, zur zweiten Prozessbox und Kühlen des zweiten Substrats,
- Entfernen der zweiten Kühleinheit, insbesondere in der einen Richtung, von der zweiten Prozessbox,
- Transportieren der ersten Be-/Entladeeinheit, insbesondere in der entgegen gesetzten Richtung, zur ersten Prozessbox und Entnehmen des ersten Substrats,
- Transportieren der zweiten Be-/Entladeeinheit, insbesondere in der einen Richtung, zur zweiten Prozessbox und Entnehmen des zweiten Substrats.

Eine weitere vorteilhafte Ausgestaltung der erfindungsgemäßen Verfahrens, bei welchem während der Wärmebehandlung eines Substrats wenigstens ein gasförmiger Stoff durch das beschichtete Substrat erzeugt wird, umfasst die folgenden Schritte:
- Temperieren bzw. aktives Kühlen wenigstens eines (ersten) Gehäuseabschnitts der Prozessbox während und gegebenenfalls nach der Wärmebehandlung,
- Hemmen der Diffusion eines während der Wärmebehandlung des Substrats erzeugten gasförmigen Stoffs zum temperierten bzw. gekühlten (ersten) Gehäuseabschnitt durch eine mit einer oder mehreren Öffnungen versehenen Trennwand, welche zwischen dem beschichteten Substrat und dem temperierten bzw. gekühlten (ersten) Gehäuseabschnitt angeordnet ist.

Im erfindungsgemäßen Verfahren wird der wenigstens eine zur Wärmebehandlung dienende Gehäuseabschnitt der Prozessbox, auf welche die Heizstrahlung auftrifft, nicht temperiert bzw. gekühlt.

Bei einer weiteren vorteilhaften Ausgestaltung des erfindungsgemäßen Verfahrens wird ein zwischen der Trennwand und dem temperierten bzw. gekühlten (ersten) Gehäuseabschnitt befindlicher Zwischenraum wenigstens teilweise, insbesondere vollständig, nicht von der elektromagnetischen Heizstrahlung bestrahlt.

Bei einer weiteren vorteilhaften Ausgestaltung des erfindungsgemäßen Verfahrens wird eine (gesamte) Öffnungsfläche der einen oder mehreren Öffnungen der Trennwand während der Wärmebehandlung durch Erwärmen der Trennwand auf maximal 50%, vorzugsweise maximal 30%, stärker bevorzugt maximal 10%, des Ausgangswerts (gesamte Öffnungsfläche vor der Wärmebehandlung) verringert.

Bei einer weiteren vorteilhaften Ausgestaltung des erfindungsgemäßen Verfahrens wird der Hohlraum der Prozessbox vor der Wärmebehandlung des beschichteten Substrats evakuiert und/oder mit einem Prozessgas (mit Unter- oder Überdruck) befüllt.

In den verschiedenen Ausgestaltungen des erfindungsgemäßen Verfahrens, bei denen die Prozessbox ortsfest ist und die Heiz-, Kühl- und Be-/Entladeeinheit relativ zur ortsfesten Prozessbox transportiert werden, können die Heiz-, Kühl- und Be-/Entladeeinheit jeweils einzeln, unabhängig von den jeweils anderen Einheiten, bewegt werden. Möglich ist jedoch auch, dass die Heiz-, Kühl- und Be-/Entladeeinheit gemeinsam (synchron) bewegt werden.

Wie beschrieben, kann die Prozessbox zum Prozessieren eines beschichteten Substrats wahlweise als transportierbare oder ortsfeste Prozessbox eingesetzt werden.

Im Sinne der Erfindung bezieht sich der Ausdruck "Substrat" auf einen flächigen Körper, der über zwei einander entgegen gesetzte Oberflächen verfügt, wobei auf einer der beiden Oberflächen ein typischer Weise eine Mehrzahl Schichten enthaltender Schichtenaufbau aufgebracht ist. Die andere Oberfläche des Substrats ist in der Regel unbeschichtet. Beispielsweise handelt es sich um ein mit Precursor- bzw. Vorläuferschichten eines Verbindungshalbleiters (z.B. Chalkopyrit- oder Kesteritverbindung) beschichtetes Substrat zur Herstellung eines Dünnschichtsolarmoduls, das einer RTP-Wärmebehandlung unterzogen werden muss.

Die Prozessbox umfasst ein Gehäuse, durch das ein gasdicht verschließbarer (evakuierbarer) Hohlraum geformt bzw. umgrenzt ist. Die lichte Höhe des Hohlraums ist vorzugsweise so bemessen, dass in möglichst kurzer Zeit Gase abgepumpt und die hohen Anforderungen bezüglich Sauerstoffgehalt und Wasserpartialdruck bei einer RTP-Wärmebehandlung erfüllt werden können. Das Gehäuse kann grundsätzlich aus jedem für die beabsichtigte Verwendung geeigneten Material, beispielsweise Metall, Glas, Keramik, Glaskeramik, carbonfaserverstärkte Kohlenstoffwerkstoffe oder Graphit, gefertigt sein.

Wesentlich hierbei ist, dass das Gehäuse der Prozessbox einen oder mehrere Gehäuseabschnitte aufweist, die jeweils dazu ausgebildet sind, eine Wärmebehandlung durch auf den Gehäuseabschnitt auftreffende elektromagnetische Heizstrahlung zu ermöglichen. Die zur Wärmebehandlung dienenden Gehäuseabschnitte können zu diesem Zweck transparent, teiltransparent oder undurchsichtig sein für elektromagnetische Heizstrahlung zum Prozessieren des Substrats. Beispielsweise bestehen die zur Wärmebehandlung dienenden Gehäuseabschnitte aus Glaskeramik. Die zur Wärmebehandlung dienenden Gehäuseabschnitte können insbesondere auch ein Material (z.B. Graphit) enthalten oder aus einem solchen bestehen, welches geeignet ist, die elektromagnetische Heizstrahlung von Heizstrahlern zumindest teilweise, insbesondere vollständig, zu absorbieren, um selbst aufgeheizt zu werden. Der aufgeheizte Gehäuseabschnitt kann dann als sekundäre Wärmequelle zum Aufheizen des Substrats dienen, was insbesondere zu einer Homogenisierung der Wärmeverteilung führen kann.

Das Gehäuse der Prozessbox umfasst weiterhin einen oder mehrere temperierbare bzw. kühlbare (erste) Gehäuseabschnitte, deren Temperatur auf einen vorgebbaren Temperaturwert einstellbar bzw. aktiv kühlbar ist. Die Gehäuseabschnitte sind zu diesem Zweck jeweils mit einer (externen) Temperier- bzw. Kühleinrichtung wärmetechnisch koppelbar bzw. gekoppelt. Des Weiteren umfasst das Gehäuse einen oder mehrere nicht temperierbare, d.h. nicht mit der Temperier- bzw. Kühleinrichtung koppelbare bzw. gekoppelte, (zweite) Gehäuseabschnitte, bei welchen es sich insbesondere um jenen Gehäuseabschnitte handelt, die eine Wärmebehandlung durch auf den Gehäuseabschnitt auftreffende elektromagnetische Heizstrahlung ermöglichen, also im Strahlungsfeld der Heizstrahler liegen.

Die temperierbaren bzw. kühlbaren Gehäuseabschnitte sind in Bezug auf die Temperatur des Substrats und jener Gehäuseabschnitte, die eine Wärmebehandlung durch auftreffende elektromagnetische Heizstrahlung ermöglichen und im Strahlungsfeld der Heizstrahler liegen, aktiv kühlbar. Die temperierbaren bzw. kühlbaren Gehäuseabschnitte der Prozessbox können vor, während und/oder nach einer Wärmebehandlung des beschichteten Substrats temperiert (aktiv gekühlt) werden.

Wie hier und im Weiteren verwendet, bezieht sich der Ausdruck "kühlbar" auf eine Temperierung bzw. Kühlung des (ersten) Gehäuseabschnitts auf eine Temperatur, die niedriger ist als die Temperatur des Substrats bei der Wärmebehandlung bzw. jener Gehäuseabschnitte, die eine Wärmebehandlung durch auftreffende elektromagnetische Heizstrahlung ermöglichen und im Strahlungsfeld der Heizstrahler liegen. Beispielsweise wird der Gehäuseabschnitt auf eine Temperatur im Bereich von 20°C bis 200°C temperiert bzw. gekühlt. Durch diese Temperierung können die in der Vakuumtechnik üblichen Kunststoffdichtungen (Elastomere, Fluorelastomere) und andere vergleichsweise kostengünstige Standardkomponenten zur Vakuumabdichtung der Prozessbox verwendet werden, die jedoch Temperaturen über 200°C dauerhaft nicht überstehen.

Weiterhin umfasst das Gehäuse der Prozessbox wenigstens eine in den Hohlraum mündende, (beispielsweise durch ein Ventil) verschließbare Gasdurchführung zum Evakuieren des Hohlraums und Einleiten von Prozessgas in den Hohlraum. Die Gasdurchführung kann zu diesem Zweck insbesondere in den Zwischenraum münden. Das Prozessgas kann beispielsweise reaktive Gase wie H₂S, H₂Se, S-Dampf, Se-Dampf oder H₂ sowie Inertgase wie N₂, He oder Ar enthalten.

In der Prozessbox ist der durch das Gehäuse ausgebildete Hohlraum durch wenigstens eine Trennwand in einen Prozessraum zum Aufnehmen des beschichteten Substrats und einen Zwischenraum unterteilt, wobei die Trennwand zwischen dem beschichteten Substrat und dem temperierten (aktiv gekühlten), d.h. mit der Kühleinrichtung koppelbaren bzw. gekoppelten, Gehäuseabschnitt angeordnet ist. Der Prozessraum wird ausschließlich von der wenigstens einen Trennwand und einem oder mehreren nicht temperierbaren, d.h. nicht mit der Kühleinrichtung gekoppelten, Gehäuseabschnitten der Prozessbox umgrenzt.

Wesentlich hierbei ist, dass die Trennwand als Diffusionsbarriere (Dampfbarriere) für einen Gasaustausch zwischen Prozess- und Zwischenraum während der Wärmebehandlung dient, jedoch zumindest zeitweilig vor und nach der Wärmebehandlung einen Gasaustausch zwischen Prozess- und Zwischenraum ermöglicht, so dass ein Abpumpen gasförmiger Stoffe aus dem Prozessraum, Spülen mit einem Spülgas, sowie eine Befüllung mit einem Prozessgas durch die Trennwand hindurch möglich ist. Die Trennwand verfügt zu diesem Zweck über eine oder mehrere Öffnungen bzw. Durchbrechungen, durch die der Prozess- und Zwischenraum strömungstechnisch miteinander verbunden sind. Allgemein können die Öffnungen jede beliebige Form aufweisen, beispielsweise eine Schlitz- oder Rundlochform, und auch randständig angeordnet sein.

Bei einer vorteilhaften Ausgestaltung reicht die Trennwand nicht bis zu einer Gehäusewand, so dass eine Öffnung, insbesondere ein Spalt, zwischen Trennwand und Gehäusewand verbleibt.

Insbesondere kann die Trennwand aus einem porösen Material oder einem mit Röhren (gerade, schräge oder gewinkelte Röhren) versehenen Material bestehen oder ein solches Material umfassen.

Beispielsweise, jedoch nicht zwingend, ist eine kleinste Abmessung, beispielsweise ein Radius oder Durchmesser, einer jeweiligen Öffnung der Trennwand größer als die mittlere freie Weglänge der Gasteilchen im Prozessraum.

Somit wird durch die Trennwand ein Prozessraum zum Prozessieren des beschichteten Substrats gebildet, der durch die Trennwand vom Zwischenraum quasi-gasdicht abgetrennt ist. Im Unterschied zu einem offenen Prozessraum, der einen freien Gasaustausch zwischen Prozessraum und äußerer Umgebung erlaubt, sowie zu einem gasdichten Prozessraum, bei dem ein solcher Gasaustausch zwischen Prozessraum und äußerer Umgebung vollständig unterbunden ist, ist der Gasaustausch zwischen Prozessraum und Zwischenraum durch die Trennwand gehemmt. Diese Dampfbarriere beruht auf der Druckabhängigkeit der freien Weglänge: bei nahezu Normaldruck (700-1000mbar) ist die Diffusion durch die vergleichsweise kleinen Öffnungen gehemmt. Wird der Zwischenraum dagegen auf Drücke im Vorvakuumbereich (10-1000pbar) abgepumpt, ist die freie Weglänge stark erhöht und die Trennwand stellt nur noch eine schwache Diffusionsbarriere für den Gasaustausch dar. Der Prozessraum kann durch die Trennwand abgepumpt werden und Prozessgas strömt nach dem Abpumpen in die Prozessbox auch in den Prozessraum. Insbesondere kann durch die quasi-gasdichte Trennwand der Partialdruck von leicht flüchtigen Chalkogenkomponenten wie Selen oder Schwefel während der Wärmebehandlung im Prozessraum zumindest weitestgehend konstant gehalten werden.

Allgemein ist die Prozessbox so ausgebildet, dass sie zur Beladung mit einem beschichteten Substrat und zum Entnehmen des prozessierten Substrats geöffnet oder verschlossen bzw. zusammengebaut und (zerstörungsfrei) wieder zerlegt werden kann.

Durch die Prozessbox können mehrere Vorteile erreicht werden. So ist durch die gasdichte Ausbildung des Hohlraums mit wenigstens einer in den Hohlraum mündenden, verschließbaren Gasdurchführung ein Evakuieren des Prozessraums, insbesondere zum Abpumpen korrosiver Prozessgase und Verringern des Sauerstoffgehalts und Wasserpartialdrucks, sowie ein Spülen mit Inertgas und Befüllen mit Prozessgas möglich. Daher ist es nicht erforderlich, Schleusen und Prozesseinheiten zur Wärmebehandlung der Substrate gasdicht bzw. evakuierbar auszuführen, so dass sich die Anlage technisch stark vereinfacht und die Kosten für deren Herstellung und Wartung erheblich verringert werden können. Die Be-/Entladestation, die Heizstation und die Kühlstation können aber wiederum von einer gemeinsamen oder jeweils einzelnen Einhausung umgeben sein, die insbesondere an eine Abluftabsaugung angeschlossen sind, die aber nicht als evakuierbare Kammern ausgebildet sind. Da korrosive Prozessgase ausschließlich im Hohlraum der Prozessbox vorhanden sind, kann ein erhöhter Verschleiß von Komponenten der Anlage wie Transportrollen zum Transport der Prozessbox oder Heizstrahler zum Wärmebehandeln des beschichteten Substrats vermieden werden. Zudem kann in vorteilhafter Weise auf bewegte Teile im vakuumfähigen Bereich (Prozessbox) der Anlage verzichtet werden. Eine Evakuierung des Hohlraums der Prozessbox kann schnell und effizient erreicht werden. Dies gilt gleichermaßen für eine Befüllung mit Prozessgas, wobei das Prozessgas kosteneffizient in minimaler Menge einsetzbar ist. Die Temperierung (aktive Kühlung) wenigstens eines Gehäuseabschnitts der Prozessbox ermöglicht eine Verringerung des Verschleißes insbesondere vakuumfähiger Komponenten der Prozessbox während der Wärmebehandlung und gegebenenfalls eine Unterstützung der aktiven Kühlung des beschichteten Substrats nach der Wärmebehandlung. Durch die als Diffusions- bzw. Dampfbarriere wirkende Trennwand kann eine Kondensation von während der Wärmebehandlung entstehenden flüchtigen Komponenten, wie der Chalkogenelemente Schwefel und Selen, auf dem temperierten (aktiv gekühlten) Gehäuseabschnitt verhindert werden, um so den Verlust an flüchtigen Komponenten in der Prozessatmosphäre zu minimieren und deren Partialdruck in der Prozessatmosphäre zumindest weitestgehend konstant zu halten. Der Verbrauch an flüchtigen Chalkogenelementen kann somit minimiert und die Qualität der hergestellten Verbindungshalbleiter verbessert werden. Zudem kann durch die Trennwand der Prozessraum gegenüber dem Hohlraum der Prozessbox noch weiter reduziert werden. Durch die gasdichte Prozessbox ist das in die Prozessbox geladene Substrat vor Umwelteinflüssen gut geschützt. In einer Fertigungsanlage kann die beladene Prozessbox zwischen verschiedenen Prozesseinheiten transportiert werden, ohne dass das beschichtete Substrat aus der Prozessbox entfernt werden muss. Die Prozessbox kann wahlfrei mit einem oder mehreren beschichteten Substraten beladen werden, wobei eine Beladung mit mehreren Substraten zur Erhöhung des Durchsatzes bevorzugt sein kann.

Wie bereits ausgeführt, wird durch die Trennwand eine quasi-gasdichte Unterteilung des Hohlraums in einen Prozess- und Zwischenraum erreicht, wobei die Trennwand zu diesem Zweck mit einer oder mehreren Öffnungen versehen ist. Die Trennwand ist so ausgebildet, dass während der Wärmebehandlung ein Massenverlust eines durch die Wärmebehandlung des beschichteten Substrats erzeugten gasförmiges Stoffs aus dem Prozessraum weniger als 50%, vorzugsweise weniger als 20%, stärker bevorzugt weniger als 10%, der während der Wärmebehandlung erzeugten Masse des gasförmigen Stoffs beträgt. Erfindungsgemäß ist die Trennwand zu diesem Zweck so ausgebildet, dass ein Flächenverhältnis, gebildet aus einer (gesamten) Öffnungsfläche der einen oder mehreren Öffnungen geteilt durch eine innere Oberfläche (Innenfläche) des Prozessraums, im Bereich von 5 x 10⁻⁵ bis 5 x 10⁻⁴ liegt. Hierdurch kann in vorteilhafter Weise erreicht werden, dass die (gesamte) Öffnungsfläche der einen oder mehreren Öffnungen der Trennwand einerseits hinreichend groß ist, um ein zügiges Evakuieren des Prozessraums sowie eine Befüllung mit Spül- bzw. Prozessgas zu ermöglichen, andererseits hinreichend klein ist, so dass die Trennwand als wirksame Dampf- bzw. Diffusionsbarriere für während der Wärmebehandlung im Prozessraum erzeugte flüchtige Komponenten dient.
Bei einer besonders vorteilhaften Ausgestaltung der Prozessbox enthält oder besteht die Trennwand aus einem Material, das einen solchen Wärmeausdehnungskoeffizienten hat, dass sich eine (gesamte) Öffnungsfläche der einen oder mehreren Öffnungen durch Erwärmen der Trennwand während der Wärmebehandlung auf maximal 50%, vorzugsweise maximal 30%, stärker bevorzugt maximal 10%, des Ausgangswerts (gesamte Öffnungsfläche vor der Wärmebehandlung) verringert. Vorteilhaft enthält oder besteht die Trennwand zu diesem Zweck aus einem Material mit einem Wärmeausdehnungskoeffizienten von mehr als 5 x 10⁻⁶ K⁻¹. Auf diese Weise wird eine temperaturgesteuerte Trennwand geschaffen, bei der einerseits im kälteren Zustand durch eine größere (gesamte) Öffnungsfläche ein besonders effizientes Abpumpen des Prozessraums sowie Befüllen des Prozessraums mit Spül- bzw. Prozessgas, andererseits im wärmeren Zustand während der Wärmebehandlung durch thermische Ausdehnung durch eine kleinere (gesamte) Öffnungsfläche eine besonders wirksame Hemmung der Diffusion von während der Wärmebehandlung erzeugten gasförmigen Stoffen vom Prozessraum in den Zwischenraum erreicht wird. Insbesondere kann die Trennwand so ausgebildet sein, dass während der Wärmebehandlung die (gesamte) Öffnungsfläche zumindest annähernd auf Null reduziert wird, so dass ein Gasaustausch zwischen Prozess- und Zwischenraum während der Wärmebehandlung praktisch vollständig unterbunden wird.

Bei einer vorteilhaften Ausgestaltung der Prozessbox umfasst das Gehäuse der Prozessbox einen Boden, einen Deckel, sowie einen Boden und Deckel miteinander verbindenden Rahmen. Der Boden und der Deckel sind beispielsweise jeweils als Platten ausführt, wobei Boden und/oder Deckel aus einem solchen Material (z.B. Glaskeramik) bestehen, dass das beschichtete Substrat durch die Strahlungsenergie einer an der Unterseite des Bodens und/oder Oberseite des Deckels zugeführten Heizstrahlung wärmebehandelt werden kann. Der temperierbare (aktiv kühlbare) Gehäuseabschnitt wird durch wenigstens einen Rahmenabschnitt gebildet. Ebenso kann der Rahmen mit der wenigstens einen in den Hohlraum mündenden, verschließbaren Gasdurchführung versehen sein, um den Hohlraum zu evakuieren und den Prozessraum während bestimmter Prozessschritte gezielt mit einer bestimmten Gasatmosphäre zu versehen.

Im montierten Zustand der Prozessbox ist der Hohlraum gasdicht ausgebildet, wobei beispielsweise der Deckel abnehmbar vom Rahmen ausgebildet sein kann, so dass der Prozessraum in einfacher Weise mit einem beschichteten Substrat beladen bzw. das prozessierte Substrat entnommen werden kann. Bei einer besonders vorteilhaften Ausgestaltung der Prozessbox umfasst der Rahmen einen mit dem Boden fest verbundenen ersten Rahmenteil und einen mit dem Deckel fest verbundenen zweiten Rahmenteil, wobei die beiden Rahmenteile zur Formung des Hohlraums gasdicht miteinander fügbar sind.

Bei einer hierzu alternativen Ausgestaltung umfasst die Prozessbox ein Gehäuse mit einem einteiligen Gehäuseabschnitt mit einer Gehäuseöffnung, die durch ein vorzugsweise temperierbares (aktiv kühlbares) Verschlussteil beispielsweise seitlich gasdicht verschließbar ist. Die Trennwand steht beispielsweise parallel zum Verschlussteil. Weiterhin gezeigt ist eine Anordnung zum Prozessieren eines beschichteten Substrats, mit einer wie oben beschrieben ausgebildeten Prozessbox, einem oder mehreren Heizstrahlern zum Erzeugen von elektromagnetischer Heizstrahlung, die benachbart zu dem wenigstens einen zur Wärmebehandlung dienenden Gehäuseabschnitt der Prozessbox angeordnet sind, sowie einer Temperier- bzw. Kühleinrichtung, welche mit dem wenigstens einen temperierbaren (aktiv kühlbaren) Gehäuseabschnitt zu dessen Temperierung (aktive Kühlung) wärmetechnisch gekoppelt ist.

In obiger Anordnung sind die Heizstrahler in besonders vorteilhafter Weise so angeordnet, dass sich der Zwischenraum wenigstens teilweise, insbesondere vollständig, außerhalb eines gemeinsamen Strahlungsfelds der Heizstrahler befindet. Durch diese Maßnahme kann erreicht werden, dass sich ein Temperaturgradient (Temperaturbarriere) zwischen der Trennwand und dem temperierbaren (aktiv gekühlten) Gehäuseabschnitt der Prozessbox einstellt. Vorzugsweise ist der Temperaturgradient dergestalt, dass an der Trennwand eine Prozesstemperatur zum Wärmebehandeln des beschichteten Substrats erreicht ist. Die Heizstrahler können zu diesem Zweck beispielsweise ausschließlich oberhalb und/oder unterhalb des Prozessraums angeordnet sein.

### Kurze Beschreibung der Zeichnungen

Die Erfindung wird nun näher erläutert, wobei Bezug auf die beigefügten Figuren genommen wird. Es zeigen in vereinfachter, nicht maßstäblicher Darstellung:
- Fig. 1: eine verallgemeinerte Querschnittsdarstellung einer Prozessbox zum Prozessieren eines beschichteten Substrats;
- Fig. 2: eine perspektivische Ansicht der Prozessbox von Fig. 1 mit einem stirnseitigen Verschlussteil;
- Fig. 3A-3C: anhand verschiedener Darstellungen ein Ausführungsbeispiel der Prozessbox von Fig. 1;
- Fig. 4: eine Variante der Prozessbox von Fig. 3A-3C mit zwei fügbaren Rahmenteilen;
- Fig. 5A-5F: verschiedene Varianten einer temperaturgesteuerten Trennwand der Prozessbox;
- Fig. 6-9: anhand schematischer Aufsichten verschiedene Ausführungsbeispiele der erfindungsgemäßen Anlage zum Prozessieren von Substraten in Prozessboxen.

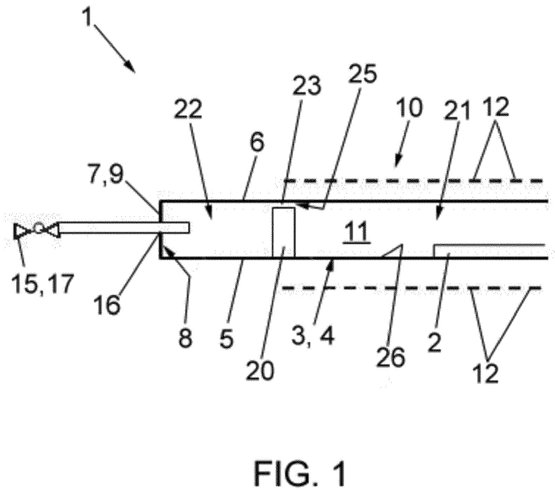

In den Figuren 1 bis 5A-5F ist eine in typischer Arbeitsposition horizontal orientierte Prozessbox veranschaulicht. Es versteht sich, dass die Prozessbox auch anders orientiert sein kann und die in der folgenden Beschreibung gemachten Lage- und Richtungsangaben sich lediglich auf die Darstellung der Prozessbox in den Figuren beziehen, wobei dies nicht als einschränkend aufzufassen ist.

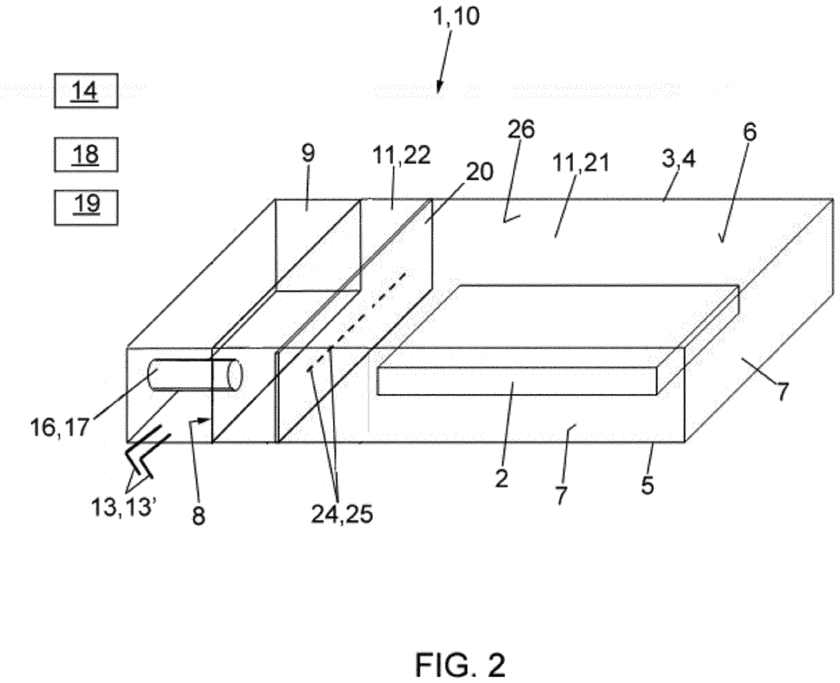

Seien zunächst Fig. 1 und 2 betrachtet, worin eine verallgemeinerte Schnittdarstellung einer Prozessbox 1 zum Prozessieren eines beschichteten Substrats 2 (Fig. 1), sowie eine perspektivische Ansicht einer solchen Prozessbox 1 mit einem stirnseitigen Verschlussteil 9 (Fig. 2) gezeigt ist.

Die Prozessbox 1 dient zum Prozessieren eines einseitig beschichteten Substrats 2 beispielsweise zur Wärmebehandlung von Vorläuferschichten zur Umsetzung zu einem Verbindungshalbleiter, insbesondere eine Chalkopyritverbindung. Obgleich nur ein einziges Substrat 2 gezeigt ist, könnte die Prozessbox 1 gleichermaßen zum Prozessieren zweier oder mehrerer Substrate 2 eingesetzt werden.

Die Prozessbox 1 umfasst ein hier beispielsweise quaderförmiges Gehäuse 3 mit einer Gehäusewand 4, die sich aus einer Bodenwand 5, einer Deckwand 6 und einer umlaufenden Seitenwand 7 zusammensetzt. Die Gehäusewand 4 umgrenzt einen gasdichten bzw. evakuierbaren Hohlraum 11, der durch ein abnehmbares Verschlussteil 9 gasdicht verschließbar ist. Wie in Fig. 2 gezeigt, weist das Gehäuse 3 beispielsweise eine stirnseitige Gehäuseöffnung 8 auf, die durch ein türartig aufsetzbares Verschlussteil 9, welches einen Teil der Seitenwand 7 bildet, verschließbar ist. Allgemein können die Gehäuseöffnung 8 und das zugehörige Verschlussteil 9 wahlfrei an einem beliebigen Wandabschnitt der Gehäusewand 4 platziert sein. Die Bodenwand 5 dient in einem mittleren Bereich als Auflagefläche für das Substrat 2, wobei gleichermaßen auch entsprechende Abstandshalter bzw. Stützelemente vorgesehen sein können.

Die Gehäusewand 4 der Prozessbox 1 kann aus einem gleichen Material oder voneinander verschiedenen Materialien bestehen. Typische Materialien sind Metall, Glas, Keramik, Glaskeramik carbonfaserverstärkte Kohlenstoffwerkstoffe oder Graphit. Wesentlich hierbei ist, dass Deckwand 6 und Bodenwand 5 jeweils so ausgebildet sind, dass eine Wärmebehandlung des beschichteten Substrats 2 durch von außen in Form von elektromagnetischer Heizstrahlung zugeführte Wärmeenergie möglich ist. Die Wärmeenergie kann in einer in Fig. 1 schematisch angedeuteten Anordnung 10 durch oberhalb der Deckwand 6 sowie unterhalb der Bodenwand 5 beispielsweise reihenförmig angeordnete Heizstrahler 12 zugeführt werden. Beispielsweise bestehen die Deckwand 6 und die Bodenwand 5 zu diesem Zweck aus einem ein Material, das transparent oder zumindest teiltransparent für die eingestrahlte elektromagnetische Strahlung ist, beispielsweise Glaskeramik. Die Deckwand 6 und die Bodenwand 5 können auch lediglich abschnittsweise aus einem solchen Material bestehen. Gleichermaßen ist es auch möglich, dass die Deckwand 6 und die Bodenwand 5 aus einem Material bestehen, welches geeignet ist, die elektromagnetische Strahlung zumindest teilweise, insbesondere vollständig, zu absorbieren, um selbst aufgeheizt zu werden, beispielsweise Graphit. In diesem Fall dienen die Deckwand 6 und die Bodenwand 5 als passiv geheizte, sekundäre Wärmequellen.

Wie in Fig. 2 erkennbar, ist die Gehäusewand 4, hier beispielsweise das Verschlussteil 9, mit zwei Kühlmittelanschlüssen 13, 13' versehen, die als Ein- bzw. Auslass für Kühlmittel in ein nicht näher dargestelltes, die umlaufende Seitenwand 7 wenigstens abschnittsweise, insbesondere vollständig, durchziehendes Kühlmittelleitungssystem dienen. Durch das eingeleitete Kühlmittel kann die Seitenwand 7 wenigstens abschnittsweise, insbesondere vollständig, auf eine voreinstellbare Temperatur temperiert bzw. in Bezug auf die Substrattemperaturen bei der Wärmebehandlung aktiv gekühlt werden. Die beiden Kühlmittelanschlüsse 13, 13' können zu diesem Zweck mit einer Temperier- bzw. Kühleinrichtung 14 zum Aufbereiten und Kühlen des Kühlmittels strömungstechnisch verbunden werden. Allgemein werden in der Prozessbox 1 nur jene Gehäuseabschnitte temperiert bzw. aktiv gekühlt, welche nicht zur Wärmebehandlung des beschichteten Substrats 2 durch von außen in Form von elektromagnetischer Heizstrahlung zugeführte Wärmeenergie dienen, hier beispielsweise die umlaufende Seitenwand 7 oder zumindest ein Abschnitt hiervon. Im vorliegenden Beispiel wird lediglich das Verschlussteil 9 temperiert bzw. gekühlt. Als Kühlmittel kann beispielsweise Öl oder Wasser verwendet werden. Die Temperierung bzw. aktive Kühlung kann alternativ auch durch eine Kontaktkühlung (Wärmeleitung) durch Kontakt mit Kühlkörpern (beispielsweise Kühlplatten), ein Gebläse (Konvektionskühlung) oder kontaktlos durch beabstandete Kühlkörper (Strahlungskühlung) erreicht werden.

Das Gehäuse 3 umfasst weiterhin eine mit einem Ventil 15 versehene Gasdurchführung 16, die in den Hohlraum 11 mündet. Die Gasdurchführung 16 ist hier beispielsweise im stirnseitigen Verschlussteil 9 angeordnet. Über einen Gasanschluss 17 kann durch Anschluss an eine Abpumpeinrichtung 18 (Vakuumpumpe) der Hohlraum 11 evakuiert werden. Zudem kann der Gasanschluss 17 an eine Gasversorgungseinrichtung 19 angeschlossen werden, um den Hohlraum 11 durch Einleiten eines inerten Spülgases zu spülen und/oder mit einem reaktiven Prozessgas zu füllen. Eine Befüllung mit dem Prozessgas kann mit Unter- oder Überdruck erfolgen. Durch das Ventil 15 (beispielsweise ein Mehrwegeventil) kann die Gasdurchführung 16 wahlfrei geöffnet bzw. gasdicht verschlossen werden. Der Hohlraum 11 hat eine relativ geringe lichte Höhe, die beispielsweise im Bereich von 7 bis 12 mm liegt, um ein zügiges Evakuieren und effizientes Befüllen mit Prozessgas zu ermöglichen.

Der Hohlraum 11 ist durch eine leistenförmige Trennwand 20 in einen Prozessraum 21 und einen Zwischenraum 22 quasi-gasdicht unterteilt, wobei das beschichtete Substrat 2 ausschließlich im Prozessraum 21 aufgenommen ist. Die Gasdurchführung 16 mündet in den Zwischenraum 22. Die Trennwand 20 ist mit einer oder mehreren Öffnungen bzw. Durchbrechungen versehen, durch welche der Prozessraum 21 mit dem Zwischenraum 22 strömungstechnisch verbunden ist.

Wie in der Vertikalschnittdarstellung von Fig. 1 erkennbar, reicht die Trennwand 20, welche sich in vertikaler Richtung von der Bodenwand 5 in Richtung zur Deckwand 6 erstreckt, nicht ganz bis zur (Innenseite der) Deckwand 6 heran, so dass ein Spalt 23 als Öffnung der Trennwand 20 verbleibt. In Fig. 2 ist eine Variante gezeigt, bei welcher sich die Trennwand 20 bis zur Deckwand 6 erstreckt und mit einer Mehrzahl, etwa mittig in einer Reihe angeordneten, horizontalen Schlitzen 24 versehen ist. Durch den Spalt 23 bzw. die Schlitze 24 ist der Prozessraum 21 mit dem Zwischenraum 22 strömungstechnisch verbunden, so dass ein wechselseitiger Gasaustausch möglich ist, jedoch aufgrund der geringen vertikalen Abmessung bzw. Höhe des Spalts 23 bzw. Schlitze 24 gehemmt ist. Die Trennwand 20 wirkt somit als Diffusions- bzw. Dampfbarriere zwischen Prozessraum 21 und Zwischenraum 22.

Die Eigenschaft der Trennwand 20 als Diffusions- bzw. Dampfbarriere zu wirken, beruht auf der Druckabhängigkeit der freien Weglänge: bei nahezu Normaldruck (700-1000mbar) ist die Diffusion durch die vergleichsweise kleine(n) Öffnung(en) der Trennwand 20 gehemmt. Wird der Zwischenraum 22 dagegen auf Drücke im Vorvakuumbereich (10-1000pbar) abgepumpt, ist die freie Weglänge stark erhöht und die Trennwand 20 stellt nur noch eine schwache Diffusionsbarriere für den Gasaustausch dar. Der Prozessraum 21 kann somit durch die Trennwand 20 hindurch abgepumpt werden und Prozessgas kann nach dem Abpumpen durch Einlass in den Zwischenraum 22 auch in den Prozessraum 21 strömen. Andererseits kann durch die Trennwand 20 der Partialdruck von leicht flüchtigen Chalkogenkomponenten, wie Selen oder Schwefel, im Prozessraum 21, die während der Wärmebehandlung vom beschichteten Substrat 2 ausdiffundieren/verdampfen, während der Wärmebehandlung des Substrats 2 zumindest weitestgehend konstant gehalten werden. Die Trennwand 20 wirkt somit beispielsweise als Selenbarriere bei der Wärmebehandlung eines Substrats 2.

Allgemein ist eine (gemeinsame) Öffnungsfläche 25 des Spalts 23 bzw. Schlitze 24 so bemessen, dass während der Wärmebehandlung des Substrats 2 ein Massenverlust eines durch die Wärmebehandlung des beschichteten Substrats 2 erzeugten gasförmiges Stoffs aus dem Prozessraum 22 weniger als 50%, vorzugsweise weniger als 20%, stärker bevorzugt weniger als 10%, der Masse des während der Wärmebehandlung im Prozessraum 21 erzeugten gasförmigen Stoffs beträgt. Zu diesem Zweck ist die Trennwand 20 so ausgebildet, dass ein Flächenverhältnis, gebildet aus der Öffnungsfläche 25 geteilt durch eine innere Oberfläche bzw. Innenfläche 26 des Prozessraums 21, im Bereich von 5 x 10⁻⁵ bis 5 x 10⁻⁴ liegt.

Beispielsweise hat die Innenfläche 26 des Prozessraums 21 eine Größe von ca. 1,2 m². Eine mittlere Spalthöhe des Spalts 23 liegt beispielsweise im Bereich von 50 bis 100 µm, entsprechend einer Öffnungsfläche 25 im Bereich von 2 bis 5 cm². Die Trennwand 20 hat beispielsweise eine Höhe von 9 mm. Aus diesen Werten ergibt sich ein Flächenverhältnis von 1,5 x 10⁻⁴.

Durch die als Dampf- bzw. Diffusionsbarriere dienende Trennwand 20 kann eine Diffusion von während der Wärmebehandlung im Prozessraum 21 entstehenden flüchtigen Komponenten in den Zwischenraum 22 zumindest weitestgehend unterbunden werden, so dass eine Kondensation der flüchtigen Komponenten an der temperierten (aktiv gekühlten) Seitenwand 7, hier speziell dem Verschlussteil 9, verhindert wird. Die Prozessatmosphäre im Prozessraum 21 kann somit zumindest annähernd konstant gehalten werden.

Wie in Fig. 2 veranschaulicht, befindet sich der Zwischenraum 22 zumindest teilweise, insbesondere vollständig, außerhalb eines (gemeinsamen) Strahlungsfelds der Heizstrahler 12, so dass sich während der Wärmebehandlung ein Temperaturgradient im Zwischenraum 22 von der Trennwand 20 zur temperierten (aktiven gekühlten) Seitenwand 7, hier speziell dem Verschlussteil 9, ausbildet. Dieser Temperaturgradient dient als "Temperaturbarriere" zum Schutz von vakuumfähigen Komponenten der Prozessbox 1 vor hoher thermischer Belastung. Zu diesem Zweck sind die Heizstrahler 12 ausschließlich ober- bzw. unterhalb des Prozessraums 21 vor bzw. bis zur Trennwand 20 angeordnet. Die Heizstrahler 12 enden jeweils zumindest einige Zentimeter vor dem Zwischenraum 22 oder Trennwand 20. Andererseits sind die Heizstrahler 12 so angeordnet, dass sich ein ansteigender Temperaturgradient derart ausbildet, dass eine gewünschte Prozesstemperatur zum Wärmebehandeln des beschichteten Substrats 2 ausgehend von der Seitenwand 7, speziell Verschlussteil 9, hin zur Trennwand 20 vor oder wenigstens auf Höhe der Trennwand 20 erreicht wird, um eine ausreichende Umsetzung der Vorläuferschichten des Substrats 2 zum Verbindungshalbleiter sicherzustellen.

In der in Fig. 1 veranschaulichten allgemeinen Ausführungsform können die Trennwand 20, der Zwischenraum 22 und der(die) temperierbare(n) bzw. kühlbare(n) Abschnitt(e) der Seitenwand 7 seitlich in einer Richtung, in zwei Richtungen oder umlaufend (Rahmen) ausgestaltet sein. In der Ausführungsform von Fig. 2 sind Trennwand 20, Zwischenraum 22 und der temperierbare bzw. kühlbare Abschnitt der Seitenwand 7 (Verschlussteil 9) nur in einer Raumrichtung ausgeführt.

Das Substrat 2 besteht beispielsweise aus Glas mit einer Dicke im Bereich von 1 mm bis 4 mm, insbesondere 2 mm bis 3 mm. Das Substrat 2 ist mit einem nicht näher dargestellten Schichtenaufbau versehen, welcher beispielsweise aus Vorläuferschichten eines Absorbers (z.B. Chalkopyrit- oder Kesteritverbindung) besteht, die einer RTP-Wärmebehandlung unterzogen werden müssen. Beispielsweise handelt es sich bei dem Schichtenaufbau um eine Abfolge der Schichten Siliziumnitrid/Molybdän/Kupfer-Indium-Gallium/Selen. Beispielsweise hat die Siliziumnitrid-Schicht eine Dicke im Bereich von 50 nm bis 300 nm, die Molybdän-Schicht eine Dicke im Bereich von 200 nm bis 700 nm, die Kupfer-Indium-Gallium-Schicht eine Dicke im Bereich von 300 nm bis 1000 nm und die Selen-Schicht eine Dicke im Bereich von 500 nm bis 2000 nm.

Die Prozessbox 1 kann in einfacher Weise automatisiert montiert und durch die Gehäuseöffnung 8 be- bzw. entladen werden. Die Trennwand 20 muss dabei jeweils beim Öffnen und Schließen so bewegt werden, dass das Substrat 2 hinein gebracht werden kann.

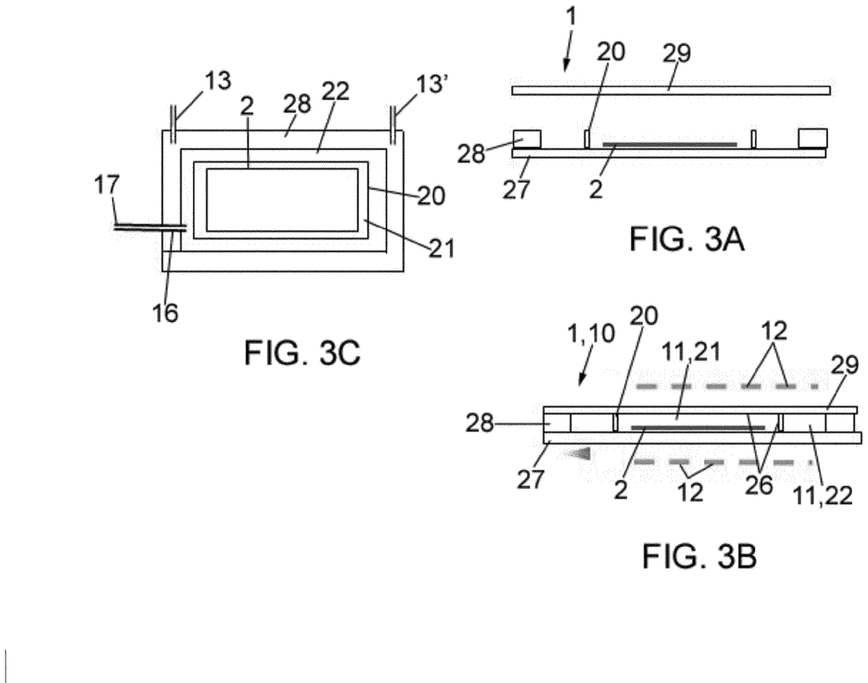

Unter Bezugnahme auf die Fig. 3A-3C wird anhand verschiedener Darstellungen ein weiteres Ausführungsbeispiel der in allgemeiner Form in Fig. 1 veranschaulichten Prozessbox 1 beschrieben.

Demnach umfasst die Prozessbox 1 eine Bodenplatte 27, auf welche in einem Randbereich ein umlaufend geschlossener Rahmen 28 lose, aber abdichtbar, aufgesetzt ist. Denkbar wäre, den Rahmen 28 mit der Bodenplatte 27 fest zu verbinden. Wie in den Vertikalschnittdarstellungen von Fig. 3A und 3B gut erkennbar, dient die Bodenplatte 27 in einem mittleren Bereich als Auflage für das Substrat 2, wobei gleichermaßen entsprechende Abstandshalter bzw. Stützelemente vorgesehen sein können. Auf den Rahmen 28 ist eine ebene Deckplatte 29 lose aufgesetzt. Durch Abnehmen der Deckplatte 29 vom Rahmen 28 kann die Prozessbox 1 in einfacher Weise mit dem beschichteten Substrat 2 insbesondere automatisiert beladen bzw. das prozessierte Substrat 2 entnommen werden. Fig. 3A zeigt die offene Prozessbox 1 mit abgehobener Deckplatte 29, Fig. 3B die geschlossene Prozessbox 1 mit auf den Rahmen 28 aufgesetzter Deckplatte 29.

In der Prozessbox 1 sind Bodenplatte 27, Rahmen 28 und Deckplatte 29 stapelförmig über- bzw. untereinander angeordnet und umgrenzen gemeinsam den gasdichten bzw. evakuierbaren Hohlraum 11. Der Hohlraum 11 ist durch die, in Entsprechung zum Rahmen 28, umlaufend geschlossen ausgebildete, leistenförmige Trennwand 20 in den (inneren) Prozessraum 21 und den umlaufenden (äußeren) Zwischenraum 22 quasi-gasdicht unterteilt. Der Zwischenraum 22 umgibt den Prozessraum 21. Analog zu Fig. 1 erstreckt sich die leistenförmige Trennwand 20 in vertikaler Richtung von der Bodenplatte 27 in Richtung zur Deckplatte 29, wobei ein enger Spalt 23 zwischen Trennwand 20 und Deckplatte 29 verbleibt. Durch den Spalt 23 ist der Prozessraum 21 mit dem Zwischenraum 22 strömungstechnisch verbunden, so dass ein wechselseitiger Gasaustausch möglich ist, wobei die Trennwand 20 jedoch als Diffusions- bzw. Dampfbarriere wirkt. Auf die diesbezüglichen Ausführungen zu Fig. 1 wird verwiesen.

Wie in Fig. 3C erkennbar, mündet die mit dem Ventil 15 versehene Gasdurchführung 16 durch den Rahmen 28 in den Zwischenraum 22, um den Hohlraum 11 zu evakuieren, mit einem inerten Spülgas (z.B N₂) zu spülen und mit einem Prozessgas zu befüllen. Das durch die Gasdurchführung 16 eingeleitete Prozessgas kann beispielsweise reaktive Gase wie H₂S, H₂Se, S-Dampf, Se-Dampf oder H₂ sowie Inertgase wie N₂, He oder Ar enthalten.

Wie weiterhin in Fig. 3C erkennbar, ist der Rahmen 28 mit den beiden Kühlmittelanschlüssen 13, 13' versehen, die als Ein- bzw. Auslass für Kühlmittel in ein nicht näher dargestelltes, den Rahmen 28 weitläufig durchziehendes Kühlmittelleitungssystem dienen. Durch das in den Rahmen 28 eingeleitete Kühlmittel kann der Rahmen 28 während und, falls gewünscht, nach der Wärmebehandlung des Substrats 2 temperiert (aktiv gekühlt) werden. Die beiden Kühlmittelanschlüsse 13, 13' sind zu diesem Zweck mit der Kühleinrichtung 14 zum Aufbereiten und Kühlen des Kühlmittels strömungstechnisch verbunden. Der Rahmen 28 besteht vorzugsweise aus einem Material mit einer hohen Wärmeleitfähigkeit, beispielsweise aus einem metallischen Material, insbesondere Edelstahl.

Die Bodenplatte 27 und die Deckplatte 29 sind jeweils so ausgebildet, dass eine Wärmebehandlung des beschichteten Substrats 2 durch oberhalb bzw. unterhalb der Prozessbox 1 in Form von elektromagnetischer Heizstrahlung zugeführte Wärmeenergie möglich ist. Auf die diesbezüglichen Ausführungen zu Fig. 1 wird verwiesen. Beispielsweise bestehen Bodenplatte 27 und die Deckplatte 29 zu diesem Zweck aus Glaskeramik.

Durch die als Dampf- bzw. Diffusionsbarriere dienende Trennwand 20 kann eine Diffusion von während der Wärmebehandlung im Prozessraum 21 entstehenden flüchtigen Komponenten in den Zwischenraum 22 zumindest weitestgehend unterbunden werden, so dass eine Kondensation der flüchtigen Komponenten am temperierten (aktiv gekühlten) Rahmen 28 verhindert wird. Die Prozessatmosphäre im Prozessraum 21 kann somit zumindest annähernd konstant gehalten werden.

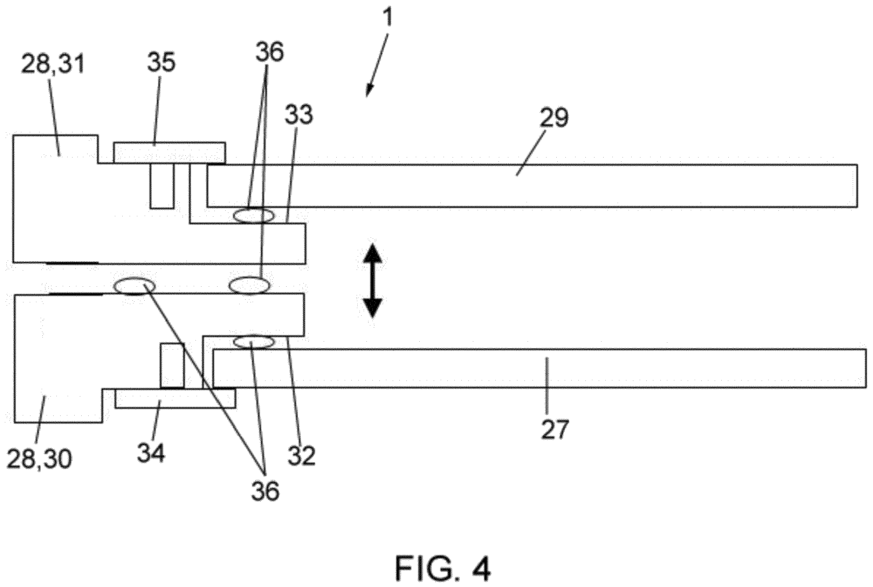

In Fig. 4 ist eine Variante der Prozessbox 1 von Fig. 3A-3C dargestellt. Um unnötige Wiederholungen zu vermeiden, werden lediglich die Unterschiede zu Fig. 3A-3C dargestellt und ansonsten wird auf die diesbezüglichen Ausführungen Bezug genommen. Demnach unterscheidet sich die Prozessbox 1 dahingehend, dass der Rahmen 28 aus zwei Rahmenteilen 30, 31 besteht, die gasdicht miteinander gefügt werden können. So ist ein unterer, erster Rahmenteil 30 vorgesehen, der über eine erste Anlagefläche 32 verfügt, gegen die die Bodenplatte 27 durch ein erstes Klemmelement 34 zur festen Verbindung geklemmt ist. In Entsprechung ist ein oberer, zweiter Rahmenteil 31 vorgesehen, der über eine zweite Anlagefläche 33 verfügt, gegen die die Deckplatte 29 durch ein zweites Klemmelement 35 zur festen Verbindung geklemmt ist. Wie durch den Doppelpfeil angedeutet, kann das zweite Rahmenteil 31 vom ersten Rahmenteil 30 abgehoben werden, um die Prozessbox 1 mit dem Substrat 2 zu beladen oder das prozessierte Substrat 2 zu entnehmen. Andererseits können die beiden Rahmenteile 30, 31 gasdicht gefügt werden, wobei durch Dichtungselemente 36 die geforderte Gasdichtigkeit sichergestellt ist. Die Prozessbox 1 zeichnet sich durch eine besondere einfach automatisierbare Be- und Entladbarkeit aus.

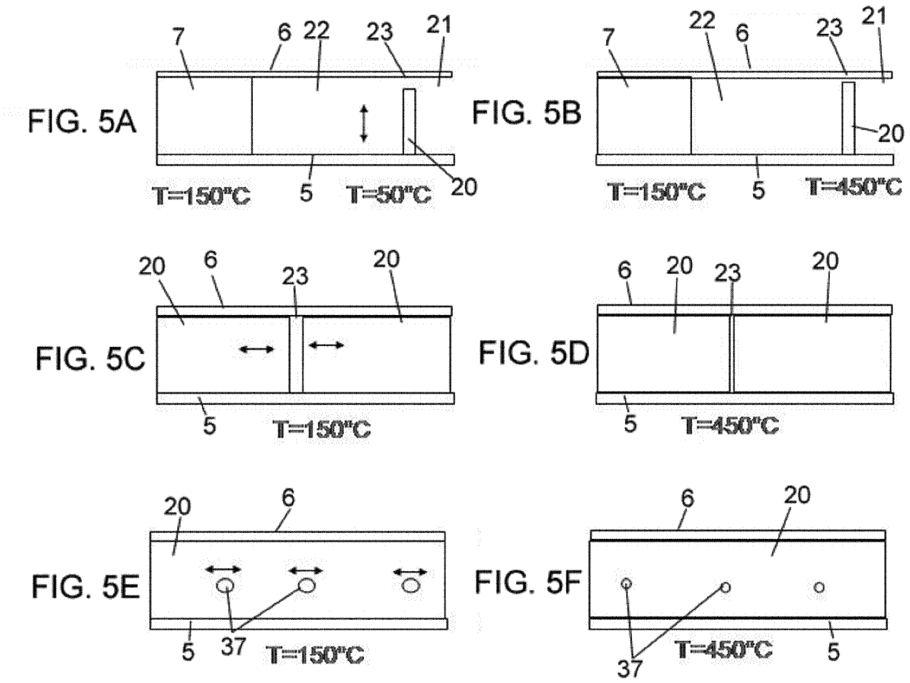

Es wird nun Bezug auf Fig. 5A-5F genommen, worin verschiedene Varianten der Trennwand 20 der Prozessbox 1 veranschaulicht sind. Es handelt sich jeweils um eine temperaturgesteuerte Trennwand 20, welche zu diesem Zweck aus einem Material besteht, das einen solchen Wärmeausdehnungskoeffizienten hat, dass sich eine gesamte Öffnungsfläche 25 der jeweiligen Öffnungen bzw. Durchbrechungen durch Erwärmen der Trennwand 12 während der Wärmebehandlung auf maximal 50%, vorzugsweise maximal 30%, stärker bevorzugt maximal 10%, des Ausgangswerts (gesamte Öffnungsfläche 25 vor der Wärmebehandlung) verringert. Die Trennwand 20 besteht zu diesem Zweck aus einem Material mit einem Wärmeausdehnungskoeffizienten von mehr als 5 x 10⁻⁶ K⁻¹. Beispiele hierfür sind bestimmte Glaskeramiken mit einem Wärmeausdehnungskoeffizienten von 9 x 10⁻⁶ K⁻¹, Aluminiumoxid (Al₂O₃) mit einem Wärmeausdehnungskoeffizienten im Bereich von 6,5 x 10⁻⁶ K⁻¹ bis 9 x 10⁻⁶ K⁻¹, Zirkonoxid und Magnesiumoxid mit einem Wärmeausdehnungskoeffizienten im Bereich von 10 x 10⁻⁶ K⁻¹ bis 13 x 10⁻⁶ K⁻¹. Das Material der Trennwand 20 muss zudem temperaturbeständig und korrosionsresistent sein.

In Fig. 5A und 5B ist die als vertikale Leiste ausgebildete Trennwand 20 der Prozessbox 1 jeweils in einer Vertikalschnittdarstellung gezeigt. Demnach reicht die Trennwand 20 nicht bis zur Deckwand 6 bzw. Deckplatte 29, so dass der Spalt 23 als Öffnung zur strömungstechnischen Verbindung von Prozessraum 21 und Zwischenraum 22 verbleibt. In Fig. 5A ist eine Situation gezeigt, bei der die Seitenwand 7 bzw. Rahmen 28 auf eine Temperatur T=150°C temperiert ist, während die Trennwand 20 eine Temperatur T=50°C hat. Das Material der Trennwand 20 ist relativ kalt, der Spalt 23 weit offen. Die vertikale Abmessung bzw. mittlere Spalthöhe (lichte Weite) des Spalts 23 liegt im Bereich von 50 bis 100 µm bei einer Höhe der Trennwand 20 von ca. 10 mm. Bei Erwärmung dehnt sich das Material der Trennwand 20 relativ stark aus, wobei sich die mittlere Spalthöhe verringert (Fig. 5B). Beispielsweise erhält man bei einer Erwärmung der Trennwand 20 auf eine Temperatur T=450°C (Temperaturdifferenz 400°C) eine Änderung der vertikalen Abmessung der Trennwand 20 von ca. 40 µm, so dass sich die mittlere Spalthöhe des Spalts 23 auf einen Wert im Bereich von 10 bis 50 µm, also maximal 50% des Ausgangswerts, verringert.

In den Fig. 5C und 5D ist anhand einer Aufsicht auf die Trennwand 20 eine Variante gezeigt. Um unnötige Wiederholungen zu vermeiden, werden lediglich die Unterschiede zu Fig. 5A und 5B erläutert und ansonsten wird auf die dortigen Ausführungen Bezug genommen. Demnach erstreckt sich die leistenförmige Trennwand 20 von der Bodenwand 5 bzw. Bodenplatte 27 zur Deckwand 6 bzw. Deckplatte 29, wobei ein oder mehrere vertikale Spalten 23 in Form von Durchbrechungen der Trennwand 20 ausgebildet sind. Die in horizontaler Richtung sich bemessende Spaltbreite liegt im Bereich von 50 bis 100 µm (Fig. 5C). Durch eine im Vergleich zur Höhe von 10 mm größere Abmessung der Trennwandbereiche zwischen zwei Spalten 23 kann bei Erwärmung der Trennwand 20 auf eine Temperatur von beispielsweise T=450°C ein relativ großer Hub erreicht werden, welcher beispielsweise mehrere 100 µm betragen kann. Insbesondere kann hierbei die gesamte Öffnungsfläche der Spalte 23 auf beispielsweise maximal 50% des Ausgangswerts reduziert werden.

In den Fig. 5E und 5F ist anhand einer Aufsicht auf die Trennwand 20 eine weitere Variante gezeigt. Um unnötige Wiederholungen zu vermeiden, werden wiederum lediglich die Unterschiede zu Fig. 5A und 5B erläutert und ansonsten wird auf die dortigen Ausführungen Bezug genommen. Demnach ist anstelle eines Spaltes 23 eine Mehrzahl Rundlöcher 37 vorgesehen, die jeweils in Form von Durchbrechungen der Trennwand 20 ausgebildet sind. Ausgehend von einer Situation, bei welcher die Temperatur der Trennwand 20 beispielsweise T=150°C beträgt (Fig. 5E), kann durch eine Erwärmung der Trennwand 20 auf eine Temperatur von beispielsweise T=450°C eine Verringerung des Öffnungsdurchmessers der Rundlöcher 37 erreicht werden (Fig. 5F). Insbesondere kann hierbei die gesamte Öffnungsfläche der Rundlöcher 37 auf beispielsweise maximal 50% des Ausgangswerts reduziert werden.

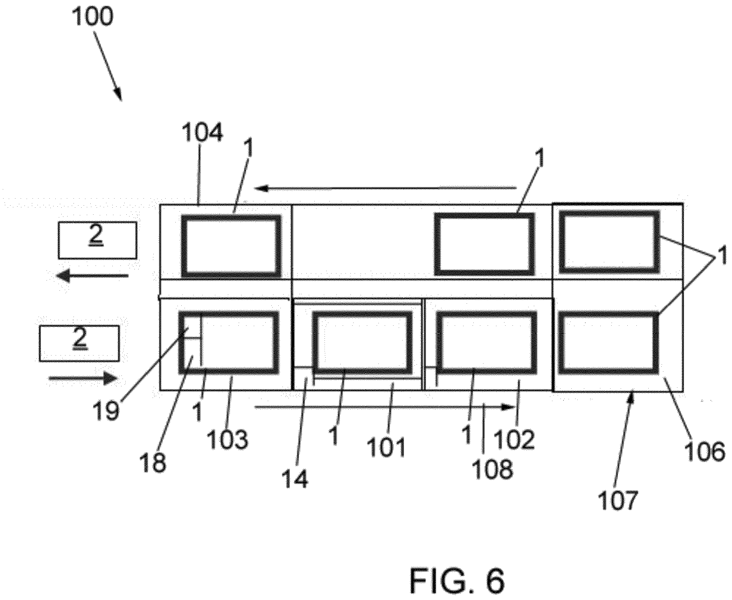

Es wird nun Bezug auf Fig. 6 genommen, worin anhand einer schematischen Aufsicht ein Ausführungsbeispiel für eine Anlage 100 zum Prozessieren von beschichteten Substraten 2 in Prozessboxen 1 gemäß Fig. 1 bis Fig. 5A-5F veranschaulicht ist. Die Anlage 100 ist für eine RTP-Wärmebehandlung von beschichteten Substraten 2 zur Herstellung von Dünnschichtsolarmodulen ausgelegt. Die Substrate 2 sind jeweils mit Vorläuferschichten eines als Absorber dienenden Verbindungshalbleiters, insbesondere vom Typ Chalkopyrit- oder Kesteritverbindung, beschichtet.

Demnach umfasst die Anlage 100 verschiedene Einheiten 101-104 zum Prozessieren der beschichteten Substrate 2 in Prozessboxen 1, die hier in Art einer In-Line-Anlage nacheinander angeordnet sind. Die verschiedenen Einheiten 101-104 sind nicht als evakuierbare Prozesskammern ausgebildet, sondern als funktionell und strukturell individualisierbare Prozesseinheiten in einem gemeinsamen Anlagenraum 106 angeordnet, der von einem Anlagengehäuse 107 umgrenzt wird. Die Einheiten 101-104 können jeweils offen im Anlagenraum 106 angeordnet oder aber von einem separaten Einrichtungsgehäuse umgeben sein, das jedoch nicht evakuierbar ist. Vorteilhaft ist das Gehäuse einer jeden Einheit an eine Abluftabsaugung angeschlossen. Wesentlich hierbei ist, dass in der Anlage 100 ausschließlich die Prozessboxen 1 als evakuierbare Anlagenkomponenten eingesetzt werden. Da mit Ausnahme der Prozessboxen 1 die Anlage 100 frei von evakuierbaren Komponenten ist, ist deren technische Umsetzung im Vergleich zu herkömmlichen In-Line-Anlagen zur RTP-Wärmebehandlung beschichteter Substrate wesentlich vereinfacht und die Investitionskosten der Anlage 100 sind erheblich niedriger.

Wie in Fig. 6 veranschaulicht, umfasst die Anlage 100 eine reihenförmige Anordnung von Einheiten 101-104, bestehend aus einer Beladeeinheit 103, einer Heizeinheit 101, einer Kühleinheit 102 und einer Entladeeinheit 104, die in dieser Abfolge entlang einer umlaufenden (geschlossenen) Transportstrecke für Prozessboxen 1 angeordnet sind.

Die Beladeeinheit 103 dient zum automatisierten Beladen einer Prozessbox 1 mit einem beschichteten Substrat 2. Zu diesem Zweck verfügt die Beladeeinheit 103 über ein logik- bzw. programmgesteuertes Greiforgan zum Öffnen und Schließen der Prozessbox 1, welches zudem für eine Handhabung des beschichteten Substrats 2 zum Einbringen in die Prozessbox 1 dient. Für die Handhabung des Substrats 2 kann auch ein separates Greiforgan vorgesehen sein. Zudem ist in die Beladeeinheit 103 eine Abpumpeinrichtung 18 zum Evakuieren des Hohlraums 11 einer Prozessbox 1 sowie eine Gasversorgungseinrichtung 19 (Gasspeisung) zum Speisen der Prozessbox 1 mit einem Spülgas und/oder Prozessgas integriert, die jeweils an den Gasanschluss 17 der Prozessbox 1 angeschlossen werden können.

Die Heizeinheit 101 dient zum Aufheizen und Wärmebehandeln eines in eine Prozessbox 1 eingebrachten Substrats 2 für eine Umsetzung der Vorläuferschichten zum Verbindungshalbleiter. Sie weist zu diesem Zweck eine Vielzahl Heizstrahler 12 auf, die beispielsweise in zwei Reihen oberhalb und unterhalb einer Prozessbox 1 angeordnet sind. Eine entsprechende Anordnung von Heizstrahlern 12 ist in Fig. 3B veranschaulicht. Zudem ist in die Heizeinheit 101 eine Temperier- bzw. Kühleinrichtung 14 zum Temperieren bzw. aktiven Kühlen eines Gehäuseabschnitts der Prozessbox 1 während der Wärmebehandlung des Substrats 2 integriert.

Die Kühleinheit 102 dient zum aktiven Kühlen eines heißen Substrats 2 nach dessen Wärmebehandlung und ist zu diesem Zweck dazu ausgebildet, eine Kontaktkühlung (Wärmeleitung) durch an die Prozessbox 1 zugestellte Kühlkörper, beispielsweise Kühlplatten, und/oder eine Kühlung durch ein Gebläse (Konvektionskühlung), beispielsweise durch einen zirkulierenden Luft-, Argon- oder Stickstoffstrom, und/oder eine kontaktlose Kühlung durch über und/oder unter der Prozessbox 1 angeordnete Kühlkörper (Strahlungskühlung), beispielsweise Kühlplatten, zu ermöglichen.

Die Entladeeinheit 104 dient zum automatisierten Entnehmen eines prozessierten Substrats 2 aus einer Prozessbox 1. Zu diesem Zweck verfügt die Entladeeinheit 104 in Entsprechung zur Beladeeinrichtung 103 über ein logik- bzw. programmgesteuertes Greiforgan zum Öffnen bzw. Schließen der Prozessbox 1.

In der Anlage 100 von Fig. 6 können beschichtete Substrate 2 in mehreren Prozessboxen 1 zeitgleich prozessiert und dabei den verschiedenen Einheiten 101-104 nacheinander zugeführt werden, wobei zu diesem Zweck ein nicht näher dargestellter unidirektionaler Transportmechanismus 108 für den Transport der Prozessboxen 1 entlang der Transportstrecke vorgesehen ist. Ein Transport der Prozessboxen 1 kann beispielsweise auf angetriebenen Transportrollen (z.B. Stummelrollen) erfolgen, welche die Prozessboxen 1 an deren unteren Bodenflächen abstützen. Die Transportgeschwindigkeit außerhalb der Einheiten 101-104 beträgt beispielsweise bis zu 1 m/s.

Der Betrieb der Anlage 100 wird an einem konkreten Beispiel aufgezeigt, wobei lediglich zur einfacheren Beschreibung der Abläufe auf die in Fig. 6 gezeigte geometrische Anordnung der Einheiten 101-104 Bezug genommen wird.

Zunächst wird ein beschichtetes Substrat 2 zur Beladeeinheit 103 gefahren, in der eine Prozessbox 1 mit dem Substrat 2 beladen wird. Hierbei wird mithilfe des Greiforgans die Prozessbox 1 geöffnet, das Substrat 2 in die Prozessbox 1 eingelegt und die Prozessbox 1 anschließend wieder geschlossen. Zudem wird der Hohlraum 11 der beladenen Prozessbox 1 durch Betrieb der Abpumpeinrichtung 18 abgepumpt bzw. evakuiert, um Sauerstoff und Wasser aus dem Hohlraum 11 zu entfernen. Zu diesem Zweck wird die Abpumpeinrichtung 18 an den Gasanschluss 17 der Prozessbox 1 automatisch angeschlossen. Der Gasanschluss 17 wird anschließend mit der Gasversorgungseinrichtung 19 verbunden und der beladene Hohlraum 11 mit einem inerten Spülgas (z.B. N₂, He oder Ar) gespült. Der Abpump- und Spülvorgang kann gegebenenfalls mehrfach wiederholt werden. Anschließend wird der Hohlraum 11 der Prozessbox 1 mit einem Prozessgas (z.B. reaktive Gase wie H₂S, H₂Se, S-Dampf, Se-Dampf sowie Inertgase wie N₂, He oder Ar) befüllt. Beispielsweise wird als Prozessgas H₂S eingefüllt (bis 200- 400 mbar). Die Prozessbox 1 kann mit Unter- oder Überdruck befüllt werden.

Die Abpumpeinrichtung 19 und die Gasversorgungseinrichtung 18 können auch gemeinsam an den Gasanschluss 17 angeschlossen sein, beispielsweise durch ein Mehrwegeventil 15. Die Prozessbox 1 ist nun für eine Wärmebehandlung des beschichteten Substrats 2 vorbereitet.

Nach Abkoppeln der Abpumpeinrichtung 19 und der Gasversorgungseinrichtung 18 von der Prozessbox 1 wird die Prozessbox 1 von der Beladeeinheit 103 zur Heizeinheit 101 transportiert und die beiden Kühlmittelanschlüsse 13, 13' der Prozessbox 1 an die Kühleinrichtung 14 angeschlossen. Dann wird eine RTP-Wärmebehandlung der Vorläuferschichten durchgeführt, wobei das beschichtete Substrat 2 beispielsweise mit einer Aufheizgeschwindigkeit von 1°C/s bis 50°C/s auf eine Temperatur von beispielsweise 350°C bis 800°C, insbesondere 400°C bis 600°C, durch die Heizstrahler 12 aufgeheizt wird. Beispielsweise werden dabei Vorläuferschichten aus Kupfer, Indium, Gallium und Selen in einer schwefel- und/oder selenhaltigen Atmosphäre in eine Halbleiterschicht der Verbindung Cu(In,Ga)(S,Se)₂ umgewandelt. Beispielsweise erfolgt eine Selenisierung und Sulfurisierung bei einem Druck in der Prozessbox 1 von weniger als 800 mbar in reinem H₂S.

Während der Wärmebehandlung durch die Heizeinheit 101 wird der Rahmen 28 der Prozessbox 1 durch zirkulierendes Kühlmittel auf eine Temperatur von beispielsweise 150°C temperiert bzw. gekühlt. Nach der Wärmebehandlung wird die Kühleinrichtung 14 von der Prozessbox 1 abgekoppelt. Alternativ wäre beispielsweise auch eine Kontaktkühlung mit Kühlkörpern über Wärmeleitung, eine Strahlungskühlung mit Kühlkörpern oder eine konvektive Kühlung zur Temperierung bzw. Kühlung des Rahmens 28 möglich.

Anschließend wird die Prozessbox 1 von der Heizeinheit 101 zur Kühleinheit 102 transportiert und das heiße Substrat 2 durch die Kühleinheit 102 gekühlt. Das heiße Substrat 2 wird beispielsweise mit bis zu 50°C/s bis zu einer prozesstechnisch notwendigen Temperatur, beispielsweise 10°C bis 380°C, abgekühlt. Zusätzlich kann eine Kühlung durch zirkulierendes Kühlmittel, das an den beiden Kühlmittelanschlüssen 13, 13' ein- bzw. ausgeleitet wird, vorgesehen sein. Die entsprechend eingerichtete Kühleinheit 102 wird zu diesen Zweck an die beiden Kühlmittelanschlüsse 13, 13' angeschlossen.

Hat das Substrat 2 die gewünschte Temperatur erreicht, wird die Prozessbox 1 von der Kühleinheit 102 zur Entladeeinheit 104 transportiert, in der durch das Greiforgan die Prozessbox 1 geöffnet und das prozessierte Substrat 2 entnommen wird, so dass es einer weiteren Bearbeitung zur Herstellung des Dünnschichtsolarmoduls zugeführt werden kann. Die Prozessbox 1 wird anschließend wieder geschlossen und entlang der Transportstrecke der Beladeeinheit 103 zugeführt, von der sie wieder mit einem zu prozessierenden Substrat 2 beladen werden kann. Die be- bzw. entladenen Prozessboxen 1 umlaufen die Transportstrecke zyklisch.

Die anhand von Fig. 6 veranschaulichte In-Line-Anlage 100 kann chargenweise beschickt werden, wobei in den verschiedenen Einheiten 101-104 beladene Prozessboxen 1 gleichzeitig prozessiert werden können. Insbesondere kann ein heißes Substrat 2 in der Kühleinheit 102 aktiv gekühlt werden, während ein weiteres Substrat 2 in der Heizeinheit 101 einer RTP-Wärmebehandlung unterzogen wird. Gleichzeitig können in der Beladeeinheit 103 und Entladeeinheit 104 Prozessboxen 1 be- bzw. entladen werden. Die Prozessboxen 1 können gemäß einer vorgebbaren Takt- bzw. Zykluszeit jeweils von einer Einheit zur nächsten befördert werden.

Obgleich dies in Fig. 6 nicht gezeigt ist, kann die Anlage 100 gleichermaßen eine Mehrzahl Heizeinheiten 101 und/oder eine Mehrzahl Kühleinheiten 102 und/oder ein oder mehrere Kühlstrecken aufweisen.

In der Anlage 100 ist es durch den Einsatz der evakuierbaren Prozessboxen 1 und der (im Unterschied zu herkömmlichen In-Line-Anlagen) fehlenden Notwendigkeit die Einheiten 101-104 zu evakuieren bzw. mit einer kontrollierten Prozessatmosphäre zu versehen, grundsätzlich möglich, die Prozessboxen 1 ortsfest zu halten und jeweils nur die jeweiligen Einheiten, d.h. Beladeeinheit 103, Entladeeinheit 104, Heizeinheit 101 und Kühleinheit 102, relativ zu den ortsfesten Prozessboxen 1 zu bewegen. So wäre denkbar, dass eine ortsfeste Prozessbox 1 durch die zugestellte Beladeeinheit 103 geöffnet, mit einem beschichteten Substrat 2 beladen und anschließend wieder geschlossen wird. Nach Abpumpen, Spülen und Befüllen des Hohlraums 11 der Prozessbox 1 mit einem Prozessgas und Entfernen der Beladeeinheit 103 werden die Heizstrahler 12 der Heizeinheit 101 zugestellt und die Wärmebehandlung des beschichteten Substrats 2 wird durchgeführt. Anschließend werden die Heizstrahler 12 entfernt und die Kühleinheit 102 wird zugestellt, um das heiße Substrat 2 zu kühlen. Schließlich wird die Kühleinheit 102 entfernt und die beladene Prozessbox 1 durch die Entladeeinheit 104 geöffnet und das prozessierte Substrat 2 aus der Prozessbox 1 entfernt. Die verschiedenen Einheiten 101-104 können hierzu beispielsweise gemeinsam (sychnron) durch den Transportmechanismus 108 entlang der umlaufenden Prozessstrecke bewegt werden. Möglich wäre aber auch eine separate Bewegung der verschiedenen Einheiten 101-104. Eine gleichzeitige Prozessierung einer Mehrzahl Substrate 2 in mehreren ortsfesten Prozessboxen 1 ist in einfacher Weise möglich. An den ortsfesten Prozessboxen 1 können die Abpumpeinrichtung 18, die Gasversorgungseinrichtung 19 und die Kühleinrichtung 14 jeweils permanent angeschlossen bleiben.

Die Anlage 100 zum Prozessieren beschichteter Substrate 2 unterscheidet sich somit grundlegend von herkömmlichen In-Line-Anlagen zur RTP-Wärmebehandlung beschichteter Substrate, da die verschiedenen Einheiten 101-104 nicht als evakuierbare Prozesskammern ausgeführt werden müssen. Zudem benötigt die Anlage 100 keine evakuierbaren Eingangs- und Ausgangsschleusen und es gibt keine bewegten Komponenten im vakuumfähigen Bereich der Anlage 100, so dass Anlagenkomponenten wie Heizstrahler, Transportrollen und andere Komponenten kostengünstig ausgeführt werden können und leicht zugänglich sind. Die Prozessboxen 1 sind die einzigen vakuumfähigen Komponenten. Bei Ausfall und Undichtigkeit einer Prozessbox 1 muss nur eine einzelne Prozessbox 1 ausgetauscht werden und die Anlage 100 kann weiter betrieben werden. Die Wärmebehandlung von Substraten 2 in ortsfesten Prozessboxen 1 ist problemlos möglich.

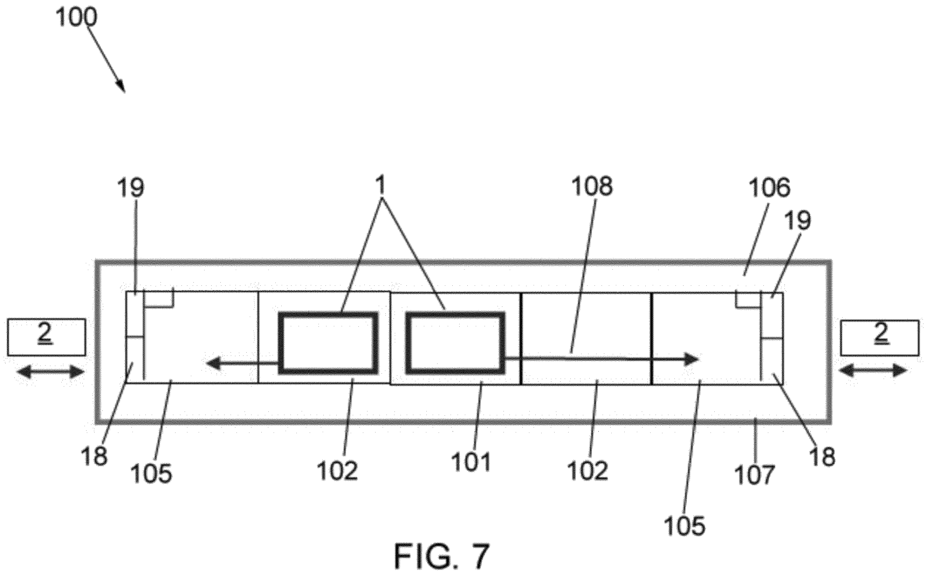

Unter Bezugnahme auf Fig. 7 wird anhand einer schematischen Aufsicht ein weiteres Ausführungsbeispiel für eine Anlage 100 zum Prozessieren von Substraten in Prozessboxen gemäß Fig. 1 bis Fig. 5A-5F beschrieben. Um unnötige Wiederholungen zu vermeiden, werden lediglich die Unterschiede zur Anlage 100 von Fig. 6 erläutert und ansonsten wird auf die dortigen Ausführungen Bezug genommen.

Demnach umfasst die Anlage 100 eine reihenförmige Anordnung von Einheiten, bestehend aus einer Heizeinheit 101, zwei Kühleinheiten 102, die sich beiderseits der Heizeinheit 101 befinden, und zwei Be-/Entladeeinheiten 105, zwischen denen sich die anderen Einheiten 101, 102 befinden.

Die Be-/Entladeeinheiten 105 sind zueinander gleich aufgebaut und dienen jeweils zum automatisierten Beladen einer Prozessbox 1 mit einem beschichteten Substrat 2 sowie zum automatisierten Entnehmen des wärmebehandelten Substrats 2 aus der Prozessbox 1, zu welchem Zweck ein Greiforgan vorgesehen ist. Zudem verfügen die Be-/Entladeeinheiten 105 jeweils über die Abpumpeinrichtung 18 zum Evakuieren des Hohlraums 11 einer Prozessbox 1 sowie über die Gasversorgungseinrichtung 19 zum Einleiten von Spülgas und/oder Prozessgas in die Prozessbox 1, die jeweils an den Gasanschluss 17 der Prozessbox 1 angeschlossen werden können. Die Heiz- und Kühleinheiten 101, 102 sind wie in der Anlage 100 von Fig. 6 aufgebaut.

In der Anlage 100 von Fig. 7 können beschichtete Substrate 2 in zwei transportierbaren Prozessboxen 1 zeitgleich prozessiert und dabei in den Prozessboxen 1 den verschiedenen Einheiten nacheinander zugeführt werden, wobei zu diesem Zweck ein nicht näher dargestellter bidirektionaler Transportmechanismus 108 vorgesehen ist.

Der Betrieb der Anlage 100 wird an einem konkreten Beispiel aufgezeigt, wobei lediglich zur einfacheren Beschreibung der Abläufe auf die in Fig. 7 gezeigte geometrische Anordnung der Einheiten 101, 102, 105 Bezug genommen wird.

Zunächst wird ein erstes Substrat 2 zur rechten Be-/Entladeeinheit 105 gefahren, wo eine erste Prozessbox 1 mit dem Substrat 2 beladen und anschließend der Hohlraum 11 der Prozessbox 1 evakuiert, mit einem Spülgas gespült und mit einem Prozessgas befüllt wird. Daraufhin wird die erste Prozessbox 1 zur Heizeinheit 101 transportiert und eine RTP-Wärmebehandlung durchgeführt. Nach Beendigung der RTP-Wärmebehandlung wird die erste Prozessbox 1 zur rechten Kühleinheit 102 transportiert, um das heiße erste Substrat 2 durch die Kühleinheit 102 zu kühlen.

Noch während der Wärmebehandlung des ersten Substrats 2 durch die Heizeinheit 101 wird ein zweites Substrat 2 zur linken Be-/Entladeeinheit 105 transportiert und in eine zweite Prozessbox 1 geladen, wobei der beladene Hohlraum 11 der zweiten Prozessbox 1 evakuiert, mit Spülgas gespült und Prozessgas befüllt wird. Im Anschluss an den Transport der ersten Prozessbox 1 von der Heizeinheit 101 zur rechten Kühleinheit 102 wird die zweite Prozessbox 1 zur Heizeinheit 101 gefahren und das zweite Substrat 2 einer Wärmebehandlung unterzogen.

Noch während der Wärmebehandlung des zweiten Substrats 2 wird das abgekühlte erste Substrat 2 zur rechten Be-/Entladeeinheit 105 transportiert und aus der ersten Prozessbox entnommen. Anschließend wird die erste Prozessbox 1 durch die rechte Be-/Entladeeinheit 105 mit einem weiteren Substrat 2 beladen und die Prozessbox durch Evakuieren, Spülen mit Spülgas und Befüllen mit Prozessgas zur Wärmebehandlung vorbereitet.

Wenn die Wärmebehandlung des in der Heizeinheit 101 befindlichen zweiten Substrats 2 beendet ist, wird die zweite Prozessbox zur linken Kühleinheit 102 transportiert und das heiße zweite Substrat 2 gekühlt. Im Anschluss daran wird die erste Prozessbox 1 mit dem weiteren Substrat zur Heizeinheit 101 zu dessen Wärmebehandlung eingefahren.

In der Anlage 100 von Fig. 7 werden die beiden Prozessboxen 1 somit zwischen der Heizeinheit 101 und der linken Be-/Entladeeinheit 105 bzw. rechten Be-/Entladeeinheit 101 hin und her bewegt. Die Prozessboxen 1 legen hierbei jeweils nur relativ kurze Transportwege zurück, so dass die Möglichkeit besteht, dass die Abpumpeinrichtung 18, die Gasversorgungseinrichtung 19 und die Kühleinrichtung 14 jeweils permanent an den beiden Prozessboxen 1 angeschlossen bleiben, beispielsweise durch flexible Leitungen (z.B. Schlauchleitungen).

In der Anlage 100 von Fig. 7 können somit zwei beschichtete Substrate 2 gleichzeitig prozessiert werden, wobei durch die beiden Be-/Entladeeinheiten 105 und die beiden Kühleinheiten 102 die Möglichkeit besteht, ein Substrat 2 durch die Heizeinheit 101 einer Wärmebehandlung zu unterziehen, während durch eine der beiden Kühleinheiten 102 ein weiteres Substrat 2 nach seiner Wärmebehandlung gekühlt wird. Da die Zeitspanne zum Abkühlen eines heißen Substrats 2 typischer Weise länger ist als die Zeitspanne zu dessen Wärmebehandlung, kann die Nutzungszeit der Heizeinheit 101, verglichen mit dem Fall, dass der Heizeinheit 101 nur eine einzige Kühleinheit 102 zugeordnet ist, erhöht werden. Durch die intensivere Auslastung der Heizeinheit 101 kann der Durchsatz an prozessierten Substraten 2 erhöht und die pro Dünnschichtsolarmodul anfallenden Produktionskosten können verringert werden.

Da die Einheiten 101, 102, 105 im Unterschied zu einer In-Line-Anlage nicht unidirektional von den Prozessboxen 1 durchlaufen werden, wäre es auch möglich, die Einheiten 101, 102, 105 nicht in einer Reihe anzuordnen, sondern beispielsweise versetzt zueinander oder sternförmig.

Die bereits zur Anlage 100 von Fig. 6 beschriebene Möglichkeit, die Substrate 2 jeweils in ortsfesten Prozessboxen 1 zu prozessieren, lässt sich mit der Anlage 100 von Fig. 7 besonders einfach realisieren, da es lediglich erforderlich ist, die jeweiligen Einheiten 101, 102, 105 mit relativ kurzen Transportwegen bezüglich der ortsfesten Prozessboxen 1 hin- und her zu bewegen. Ein Transport der Einheiten 101, 102, 105 könnte beispielsweise gemeinsam (synchron) erfolgen, wobei die rechte Be-/Entladeeinheit 105 bei einer gemeinsamen Bewegung der Einheiten 101, 102, 105 um eine Position nach rechts verschoben wird, und die linke Be-/Entladeeinheit 105 bei einer gemeinsamen Bewegung der Einheiten 101, 102, 105 um eine Position nach links verschoben wird. Möglich ist es auch, die Einheiten 101, 102, 105 in beispielsweise zwei Arbeitsebenen oberhalb der Prozessboxen 1 zu transportieren. In diesem Fall könnte beispielsweise die rechte Be-/Entladeeinheit 105 nach oben gefahren werden, um nach Beladen der rechten Prozessbox 1 die Heizeinheit 101 zur Prozessbox 1 zuzustellen. Gleichermaßen müsste die Heizeinheit 101 über die rechte Kühleinheit 102 hinweg gefahren werden, was gleichermaßen durch Ausweichen in die obere Arbeitsebene erfolgen kann. Für die linke Be-/Entladeeinheit 105 und linke Kühleinheit 102 gilt Entsprechendes.

Konkret könnte beispielsweise ein erstes Substrat 2 von der rechten Belade-/Entladeeinheit 105 in die erste Prozessbox 1 geladen und anschließend die rechte Belade-/Entladeeinheit 105 nach oben in eine zweite Arbeitsebene gefahren werden, um dann die Heizeinheit 101 zur ersten Prozessbox 1 zuzustellen. Während der Wärmebehandlung des ersten Substrats 2 wird ein zweites Substrat 2 durch die linke Be-/Entladeeinheit 105 in eine zweite Prozessbox 1 geladen. Anschließend wird die Heizeinheit 101 von der ersten Prozessbox 1 zur zweiten Prozessbox 1 gefahren, um das zweite Substrat 2 wärmezubehandeln. Dann wird die erste Kühleinheit 102 zur ersten Prozessbox 1 gefahren, um das erste Substrat 2 zu kühlen, gefolgt von einem Zustellen der rechten Be-/Entladeeinheit 105 zum Entnehmen des ersten Substrats 2 aus der ersten Prozessbox 1. In entsprechender Weise wird nach der Wärmebehandlung die zweite Kühleinheit 102 zur zweiten Prozessbox 1 gefahren, um das zweite Substrat 2 zu kühlen, gefolgt von einem Zustellen der linken Be-/Entladeeinheit 105 zum Entnehmen des zweiten Substrats 2 aus der zweiten Prozessbox 1.

Es versteht sich, dass in einer Fabrik zur Herstellung von Dünnschichtsolarmodulen ein Mehrzahl solcher Anlagen 100 parallel betrieben werden können, beispielsweise in einer Anordnung, bei der die Anlagen 100 stapelförmig nebeneinander angeordnet sind.

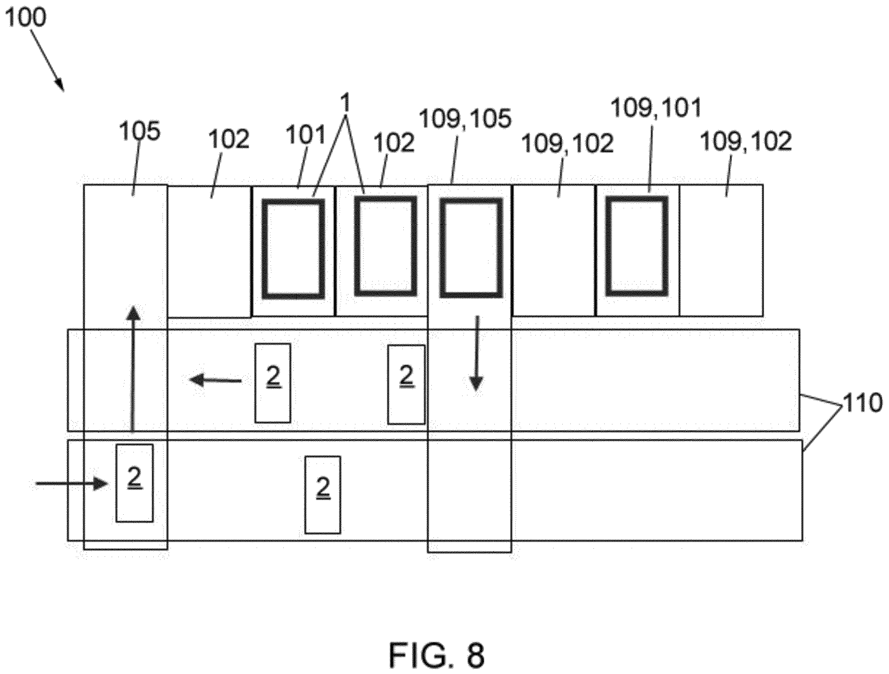

Unter Bezugnahme auf Fig. 8 wird anhand einer schematischen Aufsicht ein weiteres Ausführungsbeispiel für eine Anlage 100 zum Prozessieren von Substraten in Prozessboxen gemäß Fig. 1 bis Fig. 5A-5F beschrieben. Um unnötige Wiederholungen zu vermeiden, werden wiederum lediglich die Unterschiede zur Anlage 100 von Fig. 6 erläutert und ansonsten wird auf die dortigen Ausführungen Bezug genommen.

Demnach umfasst die Anlage 100 eine reihenförmige Anordnung von Gruppen 109 bzw. Abfolgen von Einheiten, die jeweils aus einer Kühleinheit 102, einer Heizeinheit 101, einer Kühleinheit 102 sowie einer Be-/Entladeeinheit 105 bestehen. Somit kann die Anlage 100 aus einer seriellen Anordnung einer Mehrzahl von Anlagen 100 von Fig. 7 aufgefasst werden. Die Be-/Entladeeinheiten 105 sind wie in der Anlage 100 von Fig. 7 aufgebaut. Eine Substratzufuhr erfolgt nur auf einer Seite durch zwei parallel zur Prozessstrecke verlaufende Transportlinien 110, wobei die eine Transportlinie 110 zum Antransport der zu prozessierenden Substrate 2, die andere Transportlinie 110 zum Abtransport der prozessierten Substrate 2 dient. Die Substrate 2 werden jeweils quer zur Prozessstrecke den Be-/Entladeeinheiten 105 zugeführt bzw. von diesen entfernt. Wesentlich in der Anlage 100 von Fig. 8 ist, dass jede Be-/Entladeeinheit 105 funktionell den beiderseits angrenzenden Heiz- und Kühleinheiten 101, 102 zugeordnet ist. Im Übrigen entsprechen die Abläufe zum Prozessieren der Substrate 2 jenen wie sie schon im Zusammenhang mit Fig. 7 beschrieben worden sind. Diesbezüglich wird auf die dortigen Ausführungen verwiesen.

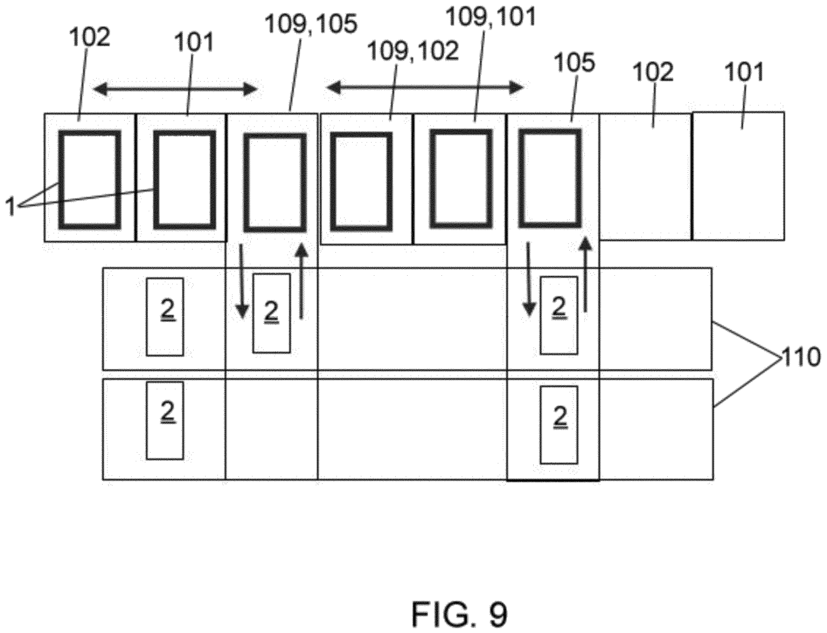

Unter Bezugnahme auf Fig. 9 wird anhand einer schematischen Aufsicht ein weiteres Ausführungsbeispiel für eine Anlage 100 zum Prozessieren von Substraten 2 in Prozessboxen 1 gemäß Fig. 1 bis Fig. 5A-5F beschrieben. Um unnötige Wiederholungen zu vermeiden, werden wiederum lediglich die Unterschiede zur Anlage 100 von Fig. 6 erläutert und ansonsten wird auf die dortigen Ausführungen Bezug genommen.

Demnach umfasst die Anlage 100 eine reihenförmige Anordnung von Gruppen 109 bzw. Abfolgen von Einheiten, die jeweils aus einer Kühleinheit 102, einer Heizeinheit 101 und einer Be-/Entladeeinheit 105 bestehen. Die Be-/Entladeeinheiten 105 sind wie in der Anlage 100 von Fig. 7 aufgebaut. Hierbei ist jede Be-/Entladeeinheit 105 funktionell nur den auf einer Seite angrenzenden Heiz- und Kühleinheit 101, 102 zugeordnet, hier beispielsweise den beiden linken Einheiten. Eine Substratzufuhr erfolgt nur auf einer Seite durch zwei Transportlinien 110, wobei die eine Transportlinie 110 zum Antransport der zu prozessierenden Substrate 2, die andere Transportlinie 110 zum Abtransport der prozessierten Substrate 2 dient. Die Substrate 2 werden jeweils quer zur Prozessstrecke den Be-/Entladeeinheiten 105 zugeführt bzw. von diesen entfernt.

In der Anlage 100 von Fig. 9 müssen die Heiz- und Kühlphasen genau abgestimmt werden, da beispielsweise die Prozessboxen 1 synchron relativ zu den ortsfesten Prozesseinheiten 101, 102, 105 hin und her bewegt werden. In einem ersten Schritt werden die in den Be-/Entladeeinheiten 105 befindlichen beladenen Prozessboxen 1 synchron um eine Position nach links zu den Heizeinheiten 101 transportiert. (Möglich wäre auch, dass die Prozessboxen 1 alternativ synchron um zwei Positionen nach rechts verschoben werden.) Nach der Wärmebehandlung werden alle Prozessboxen 1 in einem zweiten Schritt synchron um eine weitere Position nach links zu den Kühleinheiten 102 transportiert. (Möglich wäre auch, dass die Prozessboxen 1 alternativ synchron um zwei Positionen nach rechts verschoben werden.) Nach Kühlen der heißen Substrate 2 werden alle Prozessboxen 1 in einem dritten Schritt synchron um zwei Positionen nach rechts zu den Belade-/Entladeeinheiten 105 transportiert. (Möglich wäre auch, dass die Prozessboxen 1 alternativ synchron um eine Position nach links verschoben werden.) Hier erfolgt eine Entladung der Prozessboxen 1 und der Zyklus (3/3-Takt) kann von vorne beginnen.

Die Möglichkeit, die Substrate 2 jeweils in ortsfesten Prozessboxen 1 zu prozessieren, lässt sich mit der Anlage 100 von Fig. 9 besonders einfach realisieren, da es lediglich erforderlich ist, die jeweiligen Einheiten 101, 102, 105 mit relativ kurzen Transportwegen bezüglich der ortsfesten Prozessboxen 1 synchron (gemeinsam) im 3/3-Takt hin- und her zu bewegen. Die Abpumpeinrichtungen 18, die Gasversorgungseinrichtungen 19 und die Kühleinrichtungen 14 können jeweils permanent an den jeweiligen Prozessboxen 1 angeschlossen bleiben, beispielsweise über flexible Schlauchverbindungen.

### Bezugszeichenliste

- 1: Prozessbox
- 2: Substrat
- 3: Gehäuse
- 4: Gehäusewand
- 5: Bodenwand
- 6: Deckwand
- 7: Seitenwand
- 8: Gehäuseöffnung
- 9: Verschlussteil
- 10: Anordnung
- 11: Hohlraum
- 12: Heizstrahler
- 13, 13': Kühlmittelanschluss
- 14: Kühleinrichtung
- 15: Ventil
- 16: Gasdurchführung
- 17: Gasanschluss
- 18: Abpumpeinrichtung
- 19: Gasversorgungseinrichtung
- 20: Trennwand
- 21: Prozessraum
- 22: Zwischenraum
- 23: Spalt
- 24: Schlitz
- 25: Öffnungsfläche
- 26: Innenfläche
- 27: Bodenplatte
- 28: Rahmen
- 29: Deckplatte
- 30: erster Rahmenteil
- 31: zweiter Rahmenteil
- 32: erste Anlagefläche
- 33: zweite Anlagefläche
- 34: erstes Klemmelement
- 35: zweites Klemmelement
- 36: Dichtungselement
- 37: Rundloch
- 100: Anlage
- 101: Heizeinheit
- 102: Kühleinheit
- 103: Beladeeinheit
- 104: Entladeeinheit
- 105: Belade-/Entladeeinheit
- 106: Anlagenraum
- 107: Anlagengehäuse
- 108: Transportmechanismus
- 109: Gruppe
- 110: Transportlinie

## Patentansprüche

1. Anlage (100) zum Prozessieren beschichteter Substrate (2), mit den folgenden Merkmalen:
- wenigstens eine evakuierbare Prozessbox (1) zum Aufnehmen wenigstens eines Substrats (2), mit einem gasdicht verschließbaren Gehäuse (3), das einen Hohlraum (11) formt, wobei das Gehäuse (3) wenigstens einen mit einer Kühleinrichtung (14) zu dessen Kühlung koppelbaren ersten Gehäuseabschnitt (7, 9; 28) aufweist, wobei das Gehäuse wenigstens einen zweiten Gehäuseabschnitt (5, 6) umfasst, der so ausgebildet ist, dass das Substrat (2) durch auftreffende elektromagnetische Heizstrahlung wärmebehandelbar ist, wobei der wenigstens eine zweite Gehäuseabschnitt (5, 6) verschieden ist von dem wenigstens einen ersten Gehäuseabschnitt (7, 9; 28), wobei der Hohlraum (11) durch wenigstens eine Trennwand (20) in einen Prozessraum (21) zum Aufnehmen des Substrats (2) und einen Zwischenraum (22) unterteilt ist, wobei die Trennwand (20) über eine oder mehrere Öffnungen (23, 24, 37) verfügt, wobei die Trennwand (20) so ausgebildet ist, dass während der Wärmebehandlung ein Massenverlust eines durch die Wärmebehandlung des beschichteten Substrats erzeugten gasförmiges Stoffs aus dem Prozessraum weniger als 50%, vorzugsweise weniger als 20%, stärker bevorzugt weniger als 10%, der während der Wärmebehandlung erzeugten Masse des gasförmigen Stoffs beträgt, wobei ein Flächenverhältnis, gebildet aus einer Öffnungsfläche der einen oder mehreren Öffnungen geteilt durch eine innere Oberfläche des Prozessraums, im Bereich von 5 x 10⁻⁵ bis 5 x 10⁻⁴ liegt, wobei die Trennwand (20) zwischen dem Substrat (2) und dem mit der Kühleinrichtung (14) koppelbaren Gehäuseabschnitt (7, 9; 28) angeordnet ist, und wobei das Gehäuse (3) mit wenigstens einer in den Hohlraum (11) mündenden, verschließbaren Gasdurchführung (16) zum Evakuieren und Einleiten von Gas in den Hohlraum (11) versehen ist;
- eine Kühleinrichtung (14) zum Kühlen eines Gehäuseabschnitts (7, 9; 28) der Prozessbox (1);
- wenigstens eine Be-/Entladeeinheit (103-105) zum Be- und/oder Entladen der Prozessbox (1),
- wenigstens eine Heizeinheit (101) zum Aufheizen des Substrats (2) in der Prozessbox (1);
- wenigstens eine Kühleinheit (102) zum Kühlen des Substrats (2) in der Prozessbox (1);
- wenigstens eine Abpumpeinrichtung (18) zum Abpumpen des Hohlraums (11) der Prozessbox (2);
- wenigstens eine Gasversorgungseinrichtung (19) zum Speisen des Hohlraums (11) der Prozessbox (1) mit wenigstens einem Gas;
- wenigstens ein Transportmechanismus (108), welcher dazu ausgebildet ist, eine Relativbewegung zwischen einerseits der Prozessbox (1) und andererseits der Heiz- (101), Kühl- (102) und Be-/Entladeeinheit (103-105) auszuführen.

2. Anlage (100) nach Anspruch 1, bei welcher die Abpumpeinrichtung (18) und die Gasversorgungseinrichtung (19) in die Be-/Entladeeinheit (103-105) integriert sind.

3. Anlage (100) nach Anspruch 1 oder 2, bei welcher die Kühleinrichtung (14) in die Heizeinheit (101) integriert ist.

4. Anlage (100) nach einem der Ansprüche 1 bis 3, bei welcher
a) die Be-/Entladeeinheit (103-105), die Heizeinheit (101) und die Kühleinheit (102) jeweils ortsfest sind und die Prozessbox (1) transportierbar ist, wobei der Transportmechanismus (108) dazu ausgebildet ist, die Prozessbox (1) relativ zur Be-/Entladeeinheit (103-105), Heizeinheit (101) und Kühleinheit (102) zu transportieren;
oder
b) die Prozessbox (1) ortsfest ist und die Be-/Entladeeinheit (103-105), die Heizeinheit (101) und die Kühleinheit (102) jeweils transportierbar sind, wobei der Transportmechanismus (108) dazu ausgebildet ist, die Be-/Entladeeinheit(103-105), die Heizeinheit (101) und die Kühleinheit (102) relativ zur Prozessbox (1) zu transportieren.

5. Anlage (100) nach einem der Ansprüche 1 bis 3, bei welcher die Be-/Entladeeinheit (103-105), die Heizeinheit (101) und die Kühleinheit (102) entlang einer umlaufenden Transportstrecke für die Prozessbox (1) jeweils ortsfest angeordnet sind, derart, dass die Transportstrecke unidirektional durchlaufen werden kann, wobei die Prozessbox (1) transportierbar ist und der Transportmechanismus (108) dazu ausgebildet ist, die Prozessbox (1) unidirektional zu transportieren.

6. Anlage (100) nach einem der Ansprüche 1 bis 3, welche umfasst:
a) eine reihenförmige Anordnung von ortsfesten Einheiten, welche besteht aus einer Heizeinheit (101), zwei Kühleinheiten (102), die sich beiderseits der Heizeinheit (101) befinden, und zwei Be-/Entladeeinheiten (105) zum Be- und Entladen der Prozessbox (1), zwischen denen sich die anderen Einheiten (101, 102) befinden, wobei die Prozessbox (1) transportierbar ist und der Transportmechanismus (108) für einen bidirektionalen Transport der Prozessbox (1) ausgebildet ist;
oder
b) eine reihenförmige Anordnung von transportierbaren Einheiten (101, 102, 105), welche besteht aus einer Heizeinheit (101), zwei Kühleinheiten (102), die sich beiderseits der Heizeinheit (101) befinden, und zwei Be-/Entladeeinheiten (105) zum Be- und Entladen der Prozessboxen (1), zwischen denen sich die anderen Einheiten (101, 102) befinden, wobei die Prozessbox (1) ortsfest ist und der Transportmechanismus (108) für einen bidirektionalen Transport der Einheiten (101, 102, 105) ausgebildet ist.

7. Anlage (100) nach einem der Ansprüche 1 bis 3, welche umfasst:
a) eine reihenförmige Anordnung von ortsfesten Gruppen (109) von Einheiten, wobei die Gruppen (109) jeweils aus einer Kühleinheit (102), einer Heizeinheit (101), einer Kühleinheit (102) sowie einer Be-/Entladeeinheit (105) bestehen, wobei die Prozessbox (1) transportierbar ist und der Transportmechanismus (108) für einen bidirektionalen Transport der Prozessbox (1) ausgebildet ist;
oder
b) eine reihenförmige Anordnung von Gruppen (109) von Einheiten, wobei die Gruppen (109) jeweils aus einer Kühleinheit (102), einer Heizeinheit (101), einer Kühleinheit (102) sowie einer Be-/Entladeeinheit (105) bestehen, wobei die Einheiten (101, 102, 105) jeweils transportierbar sind und die Prozessbox (1) ortsfest ist, wobei der Transportmechanismus (108) für einen bidirektionalen Transport der Einheiten (101, 102, 105) ausgebildet ist.

8. Anlage (100) nach einem der Ansprüche 1 bis 3, welche umfasst:
a) eine reihenförmige Anordnung von ortsfesten Gruppen (109) von Einheiten, wobei die Gruppen (109) jeweils aus einer Kühleinheit (102), einer Heizeinheit (101) und einer Be-/Entladeeinheit (105) bestehen, wobei die Prozessbox (1) transportierbar ist und der Transportmechanismus (108) für einen bidirektionalen Transport der Prozessbox (1) ausgebildet ist;
oder
b) eine reihenförmige Anordnung von Gruppen (109) von Einheiten, wobei die Gruppen (109) jeweils aus einer Kühleinheit (102), einer Heizeinheit (101) und einer Be-/Entladeeinheit (105) bestehen, wobei die Einheiten (101, 102, 105) jeweils transportierbar sind und die Prozessbox (1) ortsfest ist, wobei der Transportmechanismus (108) für einen bidirektionalen Transport der Einheiten (101, 102, 105) ausgebildet ist.

9. Anlage (100) nach einem der Ansprüche 1 bis 8, bei welcher die Abpumpeinrichtung (18) und/oder die Gasversorgungseinrichtung (19) und/oder die Kühleinrichtung (14) während einer Relativbewegung zwischen einerseits der Prozessbox (1) und andererseits der Heiz- (101), Kühl- (102) und Be-/Entladeeinheit (103-105) permanent angekoppelt ist.

10. Verfahren zum Prozessieren beschichteter Substrate (2), welches die folgenden Schritte umfasst:
- Beladen eines Hohlraums (11) einer evakuierbaren Prozessbox (1) mit wenigstens einem beschichteten Substrat (2),
- gasdichtes Verschließen des Hohlraums (11) der Prozessbox (1),
- Abpumpen des Hohlraums (11) der Prozessbox (1),
- Füllen des Hohlraums (11) der Prozessbox (1) mit wenigstens einem Gas,
- Wärmebehandeln des Substrats (2) durch elektromagnetische Heizstrahlung, die von außerhalb der Prozessbox (2) angeordneten Heizstrahlern (12) erzeugt wird und auf wenigstens einen zur Wärmebehandlung dienenden Gehäuseabschnitt (5, 6) der Prozessbox (1) auftrifft,
- Kühlen des heißen Substrats (2),
- Entnehmen des gekühlten Substrats (1) aus der Prozessbox (1),
- Kühlen wenigstens eines Gehäuseabschnitts (7, 9; 28) der Prozessbox (1) während und gegebenenfalls nach der Wärmebehandlung,
- Hemmen der Diffusion eines während der Wärmebehandlung erzeugten gasförmigen Stoffs zum gekühlten Gehäuseabschnitt (7, 9; 28) durch eine mit einer oder mehreren Öffnungen (23, 24, 37) versehene Trennwand (20), welche zwischen dem beschichteten Substrat (2) und dem gekühlten Gehäuseabschnitt (7, 9; 28) angeordnet ist, wobei die Trennwand (20) so ausgebildet ist, dass während der Wärmebehandlung ein Massenverlust eines durch die Wärmebehandlung des beschichteten Substrats erzeugten gasförmiges Stoffs aus dem Prozessraum weniger als 50%, vorzugsweise weniger als 20%, stärker bevorzugt weniger als 10%, der während der Wärmebehandlung erzeugten Masse des gasförmigen Stoffs beträgt, wobei ein Flächenverhältnis, gebildet aus einer Öffnungsfläche der einen oder mehreren Öffnungen geteilt durch eine innere Oberfläche des Prozessraums, im Bereich von 5 x 10⁻⁵ bis 5 x 10⁻⁴ liegt, wobei die Trennwand (20).

11. Verfahren nach Anspruch 10, bei welchem die Prozessbox (1) entlang einer geschlossenen Transportstrecke unidirektional umläuft, wobei die Prozessbox (1) nacheinander zu einer Beladeeinheit (103) zum Beladen der Prozessbox (1) mit dem Substrat (2), zu wenigstens einer Heizeinheit (101) zum Wärmebehandeln des Substrats, zu wenigstens einer Kühleinheit (102) zum Kühlen des Substrats (2), und zu einer Entladeeinheit (104) zum Entnehmen des Substrats (2) aus der Prozessbox (1) transportiert wird.

12. Verfahren nach Anspruch 10, welches
a) die folgenden Schritte umfasst:
- Beladen der transportierbaren Prozessbox (1) durch eine ortsfeste Be-/Entladeeinheit (105) mit einem Substrat (2),
- Transportieren der Prozessbox (1), insbesondere in einer Richtung, zu einer ortsfesten Heizeinheit (101) und Wärmebehandeln des Substrats (1),
- Transportieren der Prozessbox (1), insbesondere in der einen oder entgegen gesetzten Richtung, zu einer ortsfesten Kühleinheit (101) und Kühlen des Substrats (2),
- Transportieren der Prozessbox (1), insbesondere in der entgegen gesetzten Richtung, zur Be-/Entladeeinheit (105) und Entnehmen des Substrats (2);
oder
b) die folgenden Schritte umfasst:
- Beladen der ortsfesten Prozessbox (1) durch eine transportierbare Be-/Entladeeinheit (105) mit einem Substrat (2),
- Entfernen der Be-/Entladeeinheit (105), insbesondere in einer Richtung, von der Prozessbox (1),
- Transportieren einer Heizeinheit (101), insbesondere in der einen Richtung, zur Prozessbox (1) und Wärmebehandeln des Substrats (1),
- Entfernen der Heizeinheit (101), insbesondere in der anderen Richtung, von der Prozessbox (1),
- Transportieren einer Kühleinheit (101), insbesondere in der einen oder entgegen gesetzten Richtung, zur Prozessbox (1) und Kühlen des Substrats (2),
- Entfernen der Kühleinheit (101), insbesondere in der einen oder entgegen gesetzten Richtung, von der Prozessbox (1),
- Transportieren der Be-/Entladeeinheit (105), insbesondere in der entgegen gesetzten Richtung, zur Prozessbox (1) und Entnehmen des Substrats (2).

13. Verfahren nach Anspruch 10, mit den folgenden Schritten:
- Beladen einer transportierbaren ersten Prozessbox (1) durch eine ortsfeste erste Be-/Entladeeinheit (105) mit einem ersten Substrat (2),
- Beladen einer transportierbaren zweiten Prozessbox (1) durch eine ortsfeste zweite Be-/Entladeeinheit (105) mit einem zweiten Substrat (2),
- Transportieren der ersten Prozessbox (1), insbesondere in einer Richtung, zu einer ortsfesten Heizeinheit (101) und Wärmebehandeln des ersten Substrats (2),
- Transportieren der ersten Prozessbox (1), insbesondere in der entgegen gesetzten Richtung, zu einer ortsfesten ersten Kühleinheit (102) und Kühlen des ersten Substrats (2),
- Transportieren der zweiten Prozessbox (1), insbesondere in der entgegen gesetzten Richtung, zur Heizeinheit (101) und Wärmebehandeln des zweiten Substrats (2),
- Transportieren der zweiten Prozessbox (1), insbesondere in der einen Richtung, zu einer ortsfesten zweiten Kühleinheit (102) und Kühlen des zweiten Substrats (2),
- Transportieren der ersten Prozessbox (1), insbesondere in der entgegen gesetzten Richtung, zur ersten Be-/Entladeeinheit (105) und Entnehmen des ersten Substrats (2),
- Transportieren der zweiten Prozessbox (1), insbesondere in der einen Richtung, zur zweiten Be-/Entladeeinheit (105) und Entnehmen des zweiten Substrats (2);
oder
- Beladen einer ortfesten ersten Prozessbox (1) durch eine erste Be-/Entladeeinheit (105) mit einem ersten Substrat (2),
- Entfernen der ersten Be-/Entladeeinheit (105), insbesondere in einer Richtung, von der ersten Prozessbox (1),
- Beladen einer ortsfesten zweiten Prozessbox (1) durch eine zweite Be-/Entladeeinheit (105) mit einem zweiten Substrat (2),
- Entfernen der zweiten Be-/Entladeeinheit (105), insbesondere in der entgegen gesetzten Richtung, von der zweiten Prozessbox (1),
- Transportieren einer Heizeinheit (101), insbesondere in der einen Richtung, zur ersten Prozessbox (1) und Wärmebehandeln des ersten Substrats (2),
- Entfernen der Heizeinheit (101), insbesondere in der entgegen gesetzten Richtung, von der ersten Prozessbox (1),
- Transportieren einer ersten Kühleinheit (102), insbesondere in der einen Richtung, zur ersten Prozessbox (1), und Kühlen des ersten Substrats (2),
- Entfernen der ersten Kühleinheit (102), insbesondere in der entgegen gesetzten Richtung, von der ersten Prozessbox (1),
- Transportieren der Heizeinheit (101), insbesondere in der entgegen gesetzten Richtung, zur zweiten Prozessbox (1) und Wärmebehandeln des zweiten Substrats (2),
- Entfernen der Heizeinheit (101), insbesondere in der einen Richtung, von der zweiten Prozessbox (1), und Wärmebehandeln des zweiten Substrats (2),
- Transportieren einer zweiten Kühleinheit (102), insbesondere in der entgegen gesetzten Richtung, zur zweiten Prozessbox (1) und Kühlen des zweiten Substrats (2),
- Entfernen der zweiten Kühleinheit (102), insbesondere in der einen Richtung, von der zweiten Prozessbox (1),
- Transportieren der ersten Be-/Entladeeinheit (105), insbesondere in der entgegen gesetzten Richtung,
zur ersten Prozessbox (1) und Entnehmen des ersten Substrats (2),
- Transportieren der zweiten Be-/Entladeeinheit (105), insbesondere in der einen Richtung, zur zweiten Prozessbox (1) und Entnehmen des zweiten Substrats (2).

## Claims

1. Installation (100) for processing coated substrates (2), with the following features:
- at least one evacuable process box (1) for accommodating at least one substrate (2), with a gas-tightly sealable housing (3), which forms a hollow space (11), wherein the housing (3) has at least one first housing section (7, 9; 28) coupable to a cooling device (14) for its cooling, wherein the housing (3) comprises at least one second housing section (5, 6), which is implemented such that the substrate (2) is thermally treatable by incident electromagnetic thermal radiation, wherein the at least one second housing section (5, 6) is different from the at least one first housing section (7, 9; 28), wherein the hollow space (11) is divided by at least one separating wall (20) into a process space (21) for accommodating the substrate (2) and an intermediate space (22), wherein the separating wall (20) has one or a plurality of openings (23, 24, 37), wherein the separating wall (20) is implemented such that during the thermal processing a loss in mass of a gaseous substance generated by the thermal processing of the coated substrate out of the process space is less than 50%, preferably less than 20%, more preferably less than 10%, of the mass of the gaseous substance generated during the thermal process, wherein an area ratio, formed from an opening area of the one or a plurality of openings divided by an inner surface of the process space, is in the range from 5 x 10⁻⁵ to 5 x 10⁻⁴, wherein the separating wall (20) is arranged between the substrate (2) and the housing section (7, 9; 28) coupleable to the cooling device (14), and wherein the housing (3) is provided with at least one sealable gas passage (16) opening into the hollow space (11), for evacuating and introducing gas into the hollow space (11);
- a cooling device (14) for cooling a housing section (7, 9; 28) of the process box (1);
- at least one loading/unloading unit (103-105) for loading and/or unloading the process box (1),
- at least one heating unit (101) for heating the substrate (2) in the process box (1);
- at least one cooling unit (102) for cooling the substrate (2) in the process box (1);
- at least one pumping-out device (18) for draining the hollow space (11) of the process box (2);
- at least one gas supply device (19) for supplying the hollow space (11) of the process box (1) with at least one gas;
- at least one transport mechanism (108), which is implemented for the purpose of executing a relative movement between, on the one hand, the process box (1) and, on the other, the heating unit (101), cooling unit (102), and loading/unloading unit (103-105).

2. Installation (100) according to claim 1, wherein the pumping-out device (18) and the gas supply device (19) are integrated into the loading/unloading unit (103-105).

3. Installation (100) according to claim 1 or 2, wherein the cooling device (14) is integrated into the heating unit (101).

4. Installation (100) according to one of claims 1 through 3, wherein
a) the loading/unloading unit (103-105), the heating unit (101), and the cooling unit (102) are each stationary and the process box (1) is transportable, wherein the transport mechanism (108) is implemented for the purpose of transporting the process box (1) relative to the loading/unloading unit (103-105), heating unit (101), and cooling unit (102);
or
b) the process box (1) is stationary and the loading/unloading unit (103-105), the heating unit (101), and the cooling unit (102) are each transportable, wherein the transport mechanism (108) is implemented for the purpose of transporting the loading/unloading unit (103-105), the heating unit (101), and the cooling unit (102) relative to the process box (1).

5. Installation (100) according to one of claims 1 through 3, wherein the loading/unloading unit (103-105), the heating unit (101), and the cooling unit (102) are each arranged stationary along a circulating transport route for the process box (1), such that the transport route can be traversed unidirectionally, wherein the process box (1) is transportable and the transport mechanism (108) is implemented for the purpose of transporting the process box (1) unidirectionally.

6. Installation (100) according to one of claims 1 through 3, which comprises:
a) a serial arrangement of stationary units, which consists of a heating unit (101), two cooling units (102), which are situated on both sides of the heating unit (101), and two loading/unloading units (105) for loading and unloading the process box (1), between which the other units (101, 102) are situated, wherein the process box (1) is transportable and the transport mechanism (108) is implemented for bidirectional transport of the process box (1);
or
b) a serial arrangement of transportable units (101, 102, 105), which consists of a heating unit (101), two cooling units (102), which are situated on both sides of the heating unit (101), and two loading/unloading units (105) for loading and unloading the process boxes (1), between which the other units (101, 102) are situated, wherein the process box (1) is stationary and the transport mechanism (108) is implemented for bidirectional transport of the units (101, 102, 105).

7. Installation (100) according to one of claims 1 through 3, which comprises:
a) a serial arrangement of stationary groups (109) of units, wherein the groups (109) consist each of a cooling unit (102), a heating unit (101), a cooling unit (102), as well as a loading/unloading unit (105), wherein the process box (1) is transportable and the transport mechanism (108) is implemented for bidirectional transport of the process box (1);
or
b) a serial arrangement of groups (109) of units, wherein the groups (109) consist each of a cooling unit (102), a heating unit (101), a cooling unit (102), as well as a loading/unloading unit (105), wherein the units (101, 102, 105) are each transportable and the process box (1) is stationary, wherein the transport mechanism (108) is implemented for bidirectional transport of the units (101, 102, 105).

8. Installation (100) according to one of claims 1 through 3, which comprises:
a) a serial arrangement of stationary groups (109) of units, wherein the groups (109) consist each of a cooling unit (102), a heating unit (101), and a loading/unloading unit (105), wherein the process box (1) is transportable and the transport mechanism (108) is implemented for bidirectional transport of the process box (1);
or
b) a serial arrangement of groups (109) of units, wherein the groups (109) consist each of a cooling unit (102), a heating unit (101), and a loading/unloading unit (105), wherein the units (101, 102, 105) are each transportable and the process box (1) is stationary, wherein the transport mechanism (108) is implemented for bidirectional transport of the units (101, 102, 105).

9. Installation (100) according to one of claims 1 through 8, wherein the pumping-out device (18) and/or the gas supply device (19) and/or the cooling device (14) is permanently coupled during a relative movement between, on the one hand, the process box (1) and, on the other, the heating unit (101), cooling unit (102), and loading/unloading unit (103-105).

10. Method for processing coated substrates (2), which comprises the following steps:
- Loading a hollow space (11) of an evacuable process box (1) with at least one coated substrate (2),
- Gas-tight sealing of the hollow space (11) of the process box (1),
- Pumping out the hollow space (11) of the process box (1),
- Filling the hollow space (11) of the process box (1) with at least one gas,
- Thermal processing of the substrate (2) by electromagnetic thermal radiation, which is generated by radiant heaters (12) arranged outside the process box (2) and impinges on at least one housing section (5, 6) of the process box (1) serving for thermal processing,
- Cooling the hot substrate (2),
- Removing the cooled substrate (1) from the process box (1),
- Cooling at least one housing section (7, 9; 28) of the process box (1) during and optionally after the thermal processing,
- Inhibiting the diffusion of a gaseous material generated during the thermal processing to the cooled housing section (7, 9; 28) by means of a separating wall (20) provided with one or a plurality of openings (23, 24, 37), which is arranged between the coated substrate (2) and the cooled housing section (7, 9; 28), wherein the separating wall (20) is implemented such that during the thermal processing a loss in mass of a gaseous substance generated by the thermal processing of the coated substrate out of the process space is less than 50%, preferably less than 20%, more preferably less than 10%, of the mass of the gaseous substance generated during the thermal process, wherein an area ratio, formed from an opening area of the one or a plurality of openings divided by an inner surface of the process space, is in the range from 5 x 10⁻⁵ to 5 x 10⁻⁴.

11. Method according to claim 10, wherein the process box (1) circulates unidirectionally along a closed transport route, wherein the process box (1) is successively transported to a loading unit (103) for loading the process box (1) with the substrate (2), to at least one heating unit (101) for thermal processing of the substrate, to at least one cooling unit (102) for cooling the substrate (2), and to one unloading unit (104) for removing the substrate (2) from the process box (1).

12. Method according to claim 10, which
a) comprises the following steps:
- Loading the transportable process box (1) by means of a stationary loading/unloading unit (105) with a substrate (2),
- Transporting the process box (1), in particular in one direction, to a stationary heating unit (101) and thermal processing of the substrate (1),
- Transporting the process box (1), in particular in the one direction or the opposite direction, to a stationary cooling unit (101) and cooling the substrate (2),
- Transporting the process box (1), in particular in the opposite direction, to the loading/unloading unit (105) and removing the substrate (2);
or
b) comprises the following steps:
- Loading the stationary process box (1) by means of a transportable loading/unloading unit (105) with a substrate (2),
- Removing the loading/unloading unit (105), in particular in one direction, from the process box (1),
- Transporting a heating unit (101), in particular in the one direction, to the process box (1) and thermal processing of the substrate (1),
- Removing the heating unit (101), in particular in the other direction, from the process box (1),
- Transporting one cooling unit (101), in particular in the one direction or the opposite direction, to the process box (1) and cooling the substrate (2),
- Removing the cooling unit (101), in particular in the one direction or the opposite direction, from the process box (1),
- Transporting loading/unloading unit (105), in particular in the opposite direction, to the process box (1) and removing the substrate (2).

13. Method according to claim 10, comprising the following steps:
- Loading a transportable first process box (1) by means of a stationary first loading/unloading unit (105) with a first substrate (2),
- Loading a transportable second process box (1) by means of a stationary second loading/unloading unit (105) with a second substrate (2),
- Transporting the first process box (1), in particular in one direction, to a stationary heating unit (101) and thermal processing of the first substrate (2),
- Transporting the first process box (1), in particular in the opposite direction, to a stationary first cooling unit (102) and cooling the first substrate (2),
- Transporting the second process box (1), in particular in the opposite direction, to the heating unit (101) and thermal processing of the second substrate (2),
- Transporting the second process box (1), in particular in the one direction, to a stationary second cooling unit (102) and cooling the second substrate (2),
- Transporting the first process box (1), in particular in the opposite direction, to the first loading/unloading unit (105) and removing the first substrate (2),
- Transporting the second process box (1), in particular in the one direction, to the second loading/unloading unit (105) and removing the second substrate (2);
or
- Loading a stationary first process box (1) by means of a first loading/unloading unit (105) with a first substrate (2),
- Removing the first loading/unloading unit (105), in particular in one direction, from the first process box (1),
- Loading a stationary second process box (1) by means of a second loading/unloading unit (105) with a second substrate (2),
- Removing the second loading/unloading unit (105), in particular in the opposite direction, from the second process box (1),
- Transporting a heating unit (101), in particular in the one direction, to the first process box (1) and thermal processing of the first substrate (2),
- Removing the heating unit (101), in particular in the opposite direction, from the first process box (1),
- Transporting a first cooling unit (102), in particular in the one direction, to the first process box (1), and cooling the first substrate (2),
- Removing the first cooling unit (102), in particular in the opposite direction, from the first process box (1),
- Transporting the heating unit (101), in particular in the opposite direction, to the second process box (1) and thermal processing of the second substrate (2),
- Removing the heating unit (101), in particular in the one direction, from the second process box (1), and thermal processing of the second substrate (2),
- Transporting a second cooling unit (102), in particular in the opposite direction, to the second process box (1) and cooling the second substrate (2),
- Removing the second cooling unit (102), in particular in the one direction, from the second process box (1),
- Transporting the first loading/unloading unit (105), in particular in the opposite direction, to the first process box (1) and removing the first substrate (2),
- Transporting the second loading/unloading unit (105), in particular in the one direction, to the second process box (1) and removing the second substrate (2).

## Revendications

1. Installation (100) pour le traitement de substrats revêtus (2), présentant les caractéristiques suivantes:
- au moins une boîte de processus (1) pouvant être mise sous vide pour recevoir au moins un substrat (2), avec un logement (3) pouvant être fermé de manière étanche aux gaz, qui forme un espace creux (11), le logement (3) présentant au moins une première partie de logement (7, 9; 28) pouvant être couplée à un dispositif de refroidissement (14) pour son refroidissement, le logement (3) comprenant au moins une deuxième partie de logement (5, 6), qui est réalisée de telle sorte que le substrat (2) peut être traité thermiquement par un rayonnement thermique électromagnétique incident, la au moins une deuxième partie de logement (5, 6) étant différente de la au moins une première partie de logement (7, 9; 28), l'espace creux (11) étant divisé par au moins une paroi de séparation (20) en un espace de processus (21) destiné à recevoir le substrat (2) et un espace intermédiaire (22), la paroi de séparation (20) présentant une ou plusieurs ouvertures (23, 24, 37), la paroi de séparation (20) étant réalisée de telle sorte que lors du traitement thermique, une perte de masse d'une substance gazeuse générée par le traitement thermique du substrat revêtu hors de l'espace de processus est inférieure à 50 %, de préférence moins de 20%, de préférence encore moins de 10%, de la masse de la substance gazeuse générée pendant le processus thermique, dans lequel un rapport de surface, formé à partir d'une surface d'ouverture d'une ou de plusieurs ouvertures divisée par une surface intérieure de l'espace de processus, se situe dans la plage de 5 x 10⁻⁵ à 5 x 10⁻⁴, dans lequel la paroi de séparation (20) est disposée entre le substrat (2) et la partie de logement (7, 9; 28) pouvant être couplée au dispositif de refroidissement (14), et dans lequel le logement (3) est pourvu d'au moins un passage de gaz (16) pouvant être fermé hermétiquement et débouchant dans l'espace creux (11), pour évacuer et introduire du gaz dans l'espace creux (11) ;
- un dispositif de refroidissement (14) pour refroidir une partie de logement (7, 9; 28) de la boîte de processus (1);
- au moins une unité de chargement/déchargement (103-105) pour le chargement et/ou le déchargement de la boîte de processus (1),
- au moins une unité de chauffage (101) pour chauffer le substrat (2) dans la boîte de processus (1);
- au moins une unité de refroidissement (102) pour refroidir le substrat (2) dans la boîte de processus (1);
- au moins un dispositif de pompage (18) pour vider l'espace creux (11) de la boîte de processus (1);
- au moins un dispositif d'alimentation en gaz (19) pour alimenter l'espace creux (11) de la boîte de processus (1) avec au moins un gaz;
- au moins un mécanisme de transport (108), qui est mis en oeuvre dans le but d'exécuter un mouvement relatif entre, d'une part, la boîte de processus (1) et, d'autre part, l'unité de chauffage (101), l'unité de refroidissement (102) et l'unité de chargement/déchargement (103-105).

2. Installation (100) selon la revendication 1, dans laquelle le dispositif de pompage (18) et le dispositif d'alimentation en gaz (19) sont intégrés dans l'unité de chargement/déchargement (103-105).

3. Installation (100) selon la revendication 1 ou 2, dans laquelle le dispositif de refroidissement (14) est intégré dans l'unité de chauffage (101).

4. Installation (100) selon l'une des revendications 1 à 3, dans laquelle
a) l'unité de chargement/déchargement (103-105), l'unité de chauffage (101) et l'unité de refroidissement (102) sont chacune stationnaires et la boîte de processus (1) est transportable, dans laquelle le mécanisme de transport (108) est mis en oeuvre dans le but de transporter la boîte de processus (1) par rapport à l'unité de chargement/déchargement (103-105), l'unité de chauffage (101) et l'unité de refroidissement (102);
ou
b) la boîte de processus (1) est fixe et l'unité de chargement/déchargement (103-105), l'unité de chauffage (101) et l'unité de refroidissement (102) sont chacune transportables, le mécanisme de transport (108) étant mis en oeuvre pour transporter l'unité de chargement/déchargement (103-105), l'unité de chauffage (101) et l'unité de refroidissement (102) par rapport à la boîte de processus (1).

5. Installation (100) selon l'une des revendications 1 à 3, dans laquelle l'unité de chargement/déchargement (103-105), l'unité de chauffage (101) et l'unité de refroidissement (102) sont chacune disposées de manière stationnaire le long d'un chemin de transport circulant pour la boîte de processus (1), de sorte que le chemin de transport peut être parcouru de manière unidirectionnelle, dans laquelle la boîte de processus (1) est transportable et le mécanisme de transport (108) est mis en oeuvre dans le but de transporter la boîte de processus (1) de manière unidirectionnelle.

6. Installation (100) selon l'une des revendications 1 à 3, qui comprend:
a) une disposition en série d'unités fixes, qui consiste en une unité de chauffage (101), deux unités de refroidissement (102), qui sont situées des deux côtés de l'unité de chauffage (101), et deux unités de chargement et de déchargement (105) pour le chargement et le déchargement de la boîte de processus (1), entre lesquelles les autres unités (101, 102) sont situées, dans laquelle la boîte de processus (1) est transportable et le mécanisme de transport (108) est mis en oeuvre pour le transport bidirectionnel de la boîte de processus (1) ;
ou
b) une disposition en série d'unités transportables (101, 102, 105), qui se compose d'une unité de chauffage (101), de deux unités de refroidissement (102), qui sont situées des deux côtés de l'unité de chauffage (101), et de deux unités de chargement/déchargement (105) pour le chargement et le déchargement des boîtes de processus (1), entre lesquelles les autres unités (101, 102) sont situées, dans laquelle la boîte de processus (1) est stationnaire et le mécanisme de transport (108) est mis en oeuvre pour le transport bidirectionnel des unités (101, 102, 105).

7. Installation (100) selon l'une des revendications 1 à 3, qui comprend:
a) une disposition en série de groupes stationnaires (109) d'unités, les groupes (109) étant constitués chacun d'une unité de refroidissement (102), d'une unité de chauffage (101), d'une unité de refroidissement (102), ainsi que d'une unité de chargement/déchargement (105), la boîte de processus (1) étant transportable et le mécanisme de transport (108) étant mis en oeuvre pour le transport bidirectionnel de la boîte de processus (1) ;
ou
b) une disposition en série de groupes (109) d'unités, dans laquelle les groupes (109) se composent chacun d'une unité de refroidissement (102), d'une unité de chauffage (101), d'une unité de refroidissement (102), ainsi que d'une unité de chargement/déchargement (105), dans laquelle les unités (101, 102, 105) sont chacune transportables et la boîte de processus (1) est stationnaire, dans laquelle le mécanisme de transport (108) est mis en oeuvre pour le transport bidirectionnel des unités (101, 102, 105).

8. Installation (100) selon l'une des revendications 1 à 3, qui comprend:
a) une disposition en série de groupes stationnaires (109) d'unités, les groupes (109) étant constitués chacun d'une unité de refroidissement (102), d'une unité de chauffage (101) et d'une unité de chargement/déchargement (105), la boîte de processus (1) étant transportable et le mécanisme de transport (108) étant mis en oeuvre pour le transport bidirectionnel de la boîte de processus (1);
ou
b) un arrangement en série de groupes (109) d'unités, dans lequel les groupes (109) se composent chacun d'une unité de refroidissement (102), d'une unité de chauffage (101) et d'une unité de chargement/déchargement (105), dans lequel les unités (101, 102, 105) sont chacune transportables et la boîte de processus (1) est stationnaire, dans lequel le mécanisme de transport (108) est mis en oeuvre pour le transport bidirectionnel des unités (101, 102, 105).

9. Installation (100) selon l'une des revendications 1 à 8, dans laquelle le dispositif de pompage (18) et/ou le dispositif d'alimentation en gaz (19) et/ou le dispositif de refroidissement (14) est couplé en permanence lors d'un mouvement relatif entre, d'une part, la boîte de processus (1) et, d'autre part, l'unité de chauffage (101), l'unité de refroidissement (102) et l'unité de chargement/déchargement (103-105).

10. Procédé de traitement de substrats revêtus (2), qui comprend les étapes suivantes:
- Chargement d'un espace creux (11) d'une boîte de processus (1) pouvant être mise sous vide avec au moins un substrat revêtu (2),
- Scellement étanche au gaz de l'espace creux (11) de la boîte de processus (1),
- Pompage de l'espace creux (11) de la boîte de processus (1),
- Remplir l'espace creux (11) de la boîte de processus (1) avec au moins un gaz,
- Traitement thermique du substrat (2) par rayonnement thermique électromagnétique, qui est généré par des radiateurs rayonnants (12) disposés à l'extérieur de la boîte de processus (2) et qui frappe au moins une partie du logement (5, 6) de la boîte de processus (1) servant au traitement thermique,
- Refroidissement du substrat chaud (2),
- Enlever le substrat refroidi (1) de la boîte de processus (1),
- Refroidissement d'au moins une partie du logement (7, 9; 28) de la boîte de processus (1) pendant et optionalement après le traitement thermique,
- Inhibition de la diffusion d'un matériau gazeux généré lors du traitement thermique vers la partie du logement refroidie (7, 9 ; 28) au moyen d'une paroi de séparation (20) munie d'une ou de plusieurs ouvertures (23, 24, 37), qui est disposée entre le substrat revêtu (2) et la partie du logement refroidie (7, 9; 28), la paroi de séparation (20) étant réalisée de telle sorte que, pendant le traitement thermique, une perte de masse d'une substance gazeuse générée par le traitement thermique du substrat revêtu en dehors de l'espace de processus est inférieure à 50 %, de préférence inférieure à 20 %, de préférence inférieure à 10 %, de la masse de la substance gazeuse générée pendant le traitement thermique, un rapport de surface, formé à partir d'une surface d'ouverture de l'une ou de plusieurs ouvertures divisée par une surface intérieure de l'espace de traitement, étant dans la plage de 5 x 10⁻⁵ à 5 x 10⁻⁴.

11. Procédé selon la revendication 10, dans lequel la boîte de processus (1) circule de manière unidirectionnelle le long d'une voie de transport fermée, dans lequel la boîte de processus (1) est transportée successivement vers une unité de chargement (103) pour charger la boîte de processus (1) avec le substrat (2), vers au moins une unité de chauffage (101) pour le traitement thermique du substrat, vers au moins une unité de refroidissement (102) pour refroidir le substrat (2), et vers une unité de déchargement (104) pour retirer le substrat (2) de la boîte de processus (1).

12. Méthode selon la revendication 10, qui
a) comprend les étapes suivantes:
- Chargement de la boîte de processus transportable (1) au moyen d'une unité de chargement/déchargement stationnaire (105) avec un substrat (2),
- Transport de la boîte de processus (1), en particulier dans un sens, vers une unité de chauffage fixe (101) et traitement thermique du substrat (1),
- Transport de la boîte de processus (1), en particulier dans un sens ou dans le sens opposé, vers une unité de refroidissement fixe (101) et refroidissement du substrat (2),
- Transport de la boîte de processus (1), en particulier dans le sens inverse, vers l'unité de chargement et de déchargement (105) et enlèvement du substrat (2);
ou
b) comprend les étapes suivantes:
- Chargement de la boîte de processus fixe (1) au moyen d'une unité de chargement/déchargement transportable (105) avec un substrat (2),
- Enlever l'unité de chargement/déchargement (105), en particulier dans un sens, de la boîte de processus (1),
- Transport d'une unité de chauffage (101), en particulier dans un sens, vers la boîte de processus (1) et traitement thermique du substrat (1),
- Enlever l'unité de chauffage (101), en particulier dans l'autre sens, de la boîte de processus (1),
- Transport d'une unité de refroidissement (101), en particulier dans un sens ou dans le sens opposé, vers la boîte de processus (1) et refroidissement du substrat (2),
- Enlever le groupe de refroidissement (101), en particulier dans un sens ou dans le sens opposé, de la boîte de processus (1),
- Transport de l'unité de chargement/déchargement (105), en particulier dans le sens inverse, vers la boîte de processus (1) et enlèvement du substrat (2).

13. Méthode selon la revendication 10, comprenant les étapes suivantes:
- Chargement d'un premier caisson de traitement transportable (1) au moyen d'une première unité de chargement/déchargement stationnaire (105) avec un premier substrat (2),
- Chargement d'une seconde boîte de processus transportable (1) au moyen d'une seconde unité de chargement/déchargement stationnaire (105) avec un second substrat (2),
- Transport de la première boîte de processus (1), en particulier dans un sens, vers une unité de chauffage fixe (101) et traitement thermique du premier substrat (2),
- Transport de la première boîte de processus (1), en particulier dans le sens inverse, vers un premier groupe de refroidissement stationaire (102) et refroidissement du premier substrat (2),
- Transport de la deuxième boîte de processus (1), en particulier dans le sens inverse, vers l'unité de chauffage (101) et traitement thermique du deuxième substrat (2),
- Transport de la deuxième boîte de processus (1), en particulier dans un sens, vers une deuxième unité de refroidissement stationaire (102) et refroidissement du deuxième substrat (2),
- Transport de la première boîte de processus (1), en particulier dans le sens inverse, vers la première unité de chargement/déchargement (105) et enlèvement du premier substrat (2),
- Transport de la deuxième boîte de processus (1), en particulier dans un sens, vers l'unité de chargement/déchargement de se-cond (105) et enlèvement du deuxième substrat (2);
ou
- Chargement d'une première boîte de processus stationnaire (1) au moyen d'une première unité de chargement/déchargement (105) avec un premier substrat (2),
- Enlever la première unité de chargement/déchargement (105), en particulier dans un sens, de la première boîte de processus (1),
- Chargement d'une seconde boîte de processus fixe (1) au moyen d'une seconde unité de chargement/déchargement (105) avec un second substrat (2),
- Enlever la deuxième unité de chargement/déchargement (105), en particulier dans la direction opposée, de la deuxième boîte de processus (1),
- Transport d'une unité de chauffage (101), en particulier dans un sens, vers la première boîte de processus (1) et traitement thermique du premier substrat (2),
- Enlever l'unité de chauffage (101), en particulier dans le sens opposé, de la première boîte de processus (1),
- Transport d'une première unité de refroidissement (102), en particulier dans un sens, vers la première boîte de processus (1), et refroidissement du premier substrat (2),
- Enlever le premier groupe de refroidissement (102), en particulier dans le sens inverse, de la première boîte de processus (1),
- Transport de l'unité de chauffage (101), en particulier dans le sens inverse, vers la deuxième boîte de processus (1) et traitement thermique du deuxième substrat (2),
- Retrait de l'unité de chauffage (101), en particulier dans un sens, de la deuxième boîte de processus (1), et traitement thermique du deuxième substrat (2),
- Transport d'un deuxième groupe de refroidissement (102), en particulier dans le sens inverse, vers la deuxième boîte de processus (1) et refroidissement du deuxième substrat (2),
- Enlever le deuxième groupe de refroidissement (102), en particulier dans un sens, de la deuxième boîte de processus (1),
- Transport de la première unité de chargement/déchargement (105), en particulier dans le sens inverse, vers la première boîte de processus (1) et enlèvement du premier substrat (2),
- Transport de la deuxième unité de chargement/déchargement (105), en particulier dans un sens, vers la deuxième boîte de processus (1) et enlèvement du deuxième substrat (2).
